(19) Europäisches Patentamt
European Patent Office
Office européen des brevets

(11) EP 4 753 013 A1

(12) # EUROPEAN PATENT APPLICATION

(43) Date of publication:
**03.06.2026 Bulletin 2026/23**

(21) Application number: **25218469.2**

(22) Date of filing: **25.11.2025**

(51) International Patent Classification (IPC):
***H01M 10/42*** *(2006.01)* ***G01R 31/367*** *(2019.01)*
***G01R 31/378*** *(2019.01)* ***G01R 31/382*** *(2019.01)*
***G01R 31/387*** *(2019.01)* ***H01M 10/48*** *(2006.01)*
***H01M 4/58*** *(2010.01)*

(52) Cooperative Patent Classification (CPC):
**H01M 10/48; G01R 31/367; G01R 31/378; G01R 31/382; G01R 31/387; H01M 4/5825; H01M 10/425; H01M 10/4264; H01M 10/4285;**
H01M 2010/4278

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **28.11.2024 KR 20240174220**

(71) Applicant: **Samsung SDI Co., Ltd.**
**Yongin-si, Gyeongsangnam-do 17084 (KR)**

(72) Inventors:
- **KIM, Hwa-Su**
  **Yongin-si, 17084 (KR)**
- **LEE, Kyungsub**
  **Yongin-si, 17084 (KR)**

(74) Representative: **Marks & Clerk LLP**
**15 Fetter Lane**
**London EC4A 1BW (GB)**

(54) **APPARATUS AND METHOD FOR GENERATING LFP BATTERY MODEL**

(57) Disclosed are an apparatus and a method for generating an LFP battery model. The apparatus for generating an LFP battery model according to the present disclosure includes a lithium state recording unit that records a state of lithium (Li) in a positive electrode active material of a lithium iron phosphate ($LiFePO_4$, LFP) battery according to charging or discharging of the LFP battery; and a battery model generating unit that generates a battery model of the LFP battery based on the recorded state of lithium in the positive electrode active material, wherein the battery model generating unit may generate a battery model by modeling the LFP battery with multiple resistors and capacitors reflecting the state of lithium in the positive electrode active material.

FIG. 7

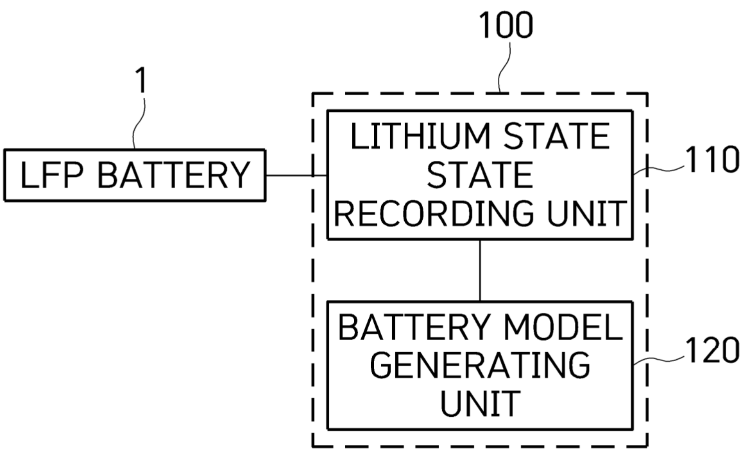


EP 4 753 013 A1

## Description

### FIELD

Aspects of embodiments of the present disclosure relate to an apparatus and a method for generating a lithium iron phosphate ($LiFePO_4$, LFP) battery model, and in particular, to an apparatus and a method for generating an LFP battery model recording a state of lithium (Li) in a positive electrode active material of an LFP battery according to charging or discharging of the LFP battery, and generating a battery model of the LFP battery based on the recorded state of lithium in the positive electrode active material.

### BACKGROUND

Unlike primary batteries that are not designed to be charged, secondary batteries are designed to be discharged and recharged. Low-capacity secondary batteries are used in small portable electronic devices, such as smart phones, feature phones, notebook computers, digital cameras, and camcorders, while large-capacity secondary batteries are widely used as power sources for driving motors, such as of hybrid vehicles or electric vehicles, and for power storage. The secondary battery includes an electrode assembly consisting of a positive electrode and a negative electrode, a case that accommodates the electrode assembly, a terminal part connected to the electrode assembly, etc.

Lithium ion batteries are classified by materials that form a positive electrode material. When classifying lithium ion batteries by a positive electrode material, there are 'ternary batteries' and 'quaternary batteries' formed with a lithium cobalt oxide (LCO) positive electrode material, and 'LFP batteries' formed with lithium iron phosphate ($LiFePO_4$, LFP) positive electrode material using iron phosphate instead of cobalt. The LFP batteries use inexpensive iron phosphate instead of expensive cobalt, and therefore, may lower the price of raw materials introduced for battery manufacturing, and are stable by having an 'olivine structure' formed in a hexagon shape among the positive electrode material structures. Accordingly, the LFP batteries have advantages of low risk of accidents caused by overcharge and overdischarge, and long battery lifetime due to less deterioration of battery cells.

A battery pack including a plurality of battery cells may include a battery management system (BMS) that manages the plurality of battery cells such as monitoring voltage, current, temperature and the like of the plurality of battery cells included in the battery pack.

It is desired to develop a battery model in order to implement an algorithm that calculates a state of charge (SOC), a state of health (SOH) and the like of a battery used in the BMS, however, an ECM (equivalent circuit model) method alone used in a comparative ternary system which does not implement aspects of the present disclosure is not able to reflect at all a unique characteristic of LFP in which internal resistance changes depending on charging and discharging paths. Accordingly, the comparative ECM method increases errors in the battery model, ultimately leading to problems of increasing errors in SOC and SOH.

The above information disclosed in this Background section is for enhancement of understanding of the background of the present disclosure, and therefore, it may contain information that does not constitute related (or prior) art.

### SUMMARY

The present disclosure has been made in view of the above, and is directed to providing an apparatus and a method for generating an LFP battery model recording a state of lithium (Li) in a positive electrode active material of a lithium iron phosphate ($LiFePO_4$, LFP) battery according to charging or discharging of the LFP battery, and generating a battery model of the LFP battery based on the recorded state of lithium in the positive electrode active material.

However, the technical problem to be solved by the present disclosure is not limited to the above problem, and other problems not mentioned herein, and aspects and features of the present disclosure that would address such problems, will be clearly understood by those skilled in the art from the description of the present disclosure herein.

An apparatus for generating an LFP battery model according to embodiments of the present disclosure includes: a lithium state recording unit that records a state of lithium (Li) in positive electrode active material of a lithium iron phosphate ($LiFePO_4$, LFP) battery according to charging or discharging of the LFP battery; and a battery model generating unit that generates a battery model of the LFP battery based on the recorded state of lithium in the positive electrode active material, wherein the battery model generating unit may generate a battery model by modeling the LFP battery with multiple resistors and capacitors reflecting the state of lithium in the positive electrode active material.

In embodiments, the lithium state recording unit may record a distribution state of lithium from a peripheral portion to a center in the positive electrode active material of the LFP battery, which changes depending on charging or discharging of the LFP battery.

In embodiments, the battery model generating unit may generate a battery model of the LFP battery in a form

including a first resistance and a second resistance in an equivalent circuit model (ECM).

In embodiments, the battery model generating unit may generate a battery model of the LFP battery by dividing the state of the lithium into a first case in which lithium is not distributed in a peripheral portion of the positive electrode active material of the LFP battery when charging the LFP battery and a second case in which lithium is distributed in a peripheral portion of the positive electrode active material of the LFP battery when charging the LFP battery.

In embodiments, in the first case generated in the battery model generating unit, the first resistance may be a drop resistance considering a voltage difference between a voltage of the LFP battery measured according to at least one of a state of charge (SOC), a charge and discharge rate (c-rate) and a temperature, and an open circuit voltage (OCV) according to at least one of the SOC and the temperature, and the second resistance may be 0.

In embodiments, when the drop resistance is R_vdrop(soc, c-rate, temp), the voltage of the LFP battery measured according to at least one of an SOC, a charge and discharge rate and a temperature is V_measurement (soc, c-rate, temp), the OCV according to at least one of the SOC and the temperature is V_ocv_ch (soc, temp), and a current flowing through the drop resistance according to the charge and discharge rate is I_c-rate, the first resistance R_a may be calculated by the following equation.

[Equation]

$$\begin{aligned} R_a &= R_vdrop(soc,\ c\text{-}rate,\ temp) \\ &= (V_measurement(soc,\ c\text{-}rate,\ temp) - V_ocv_ch(soc,\ temp))/I_c\text{-}rate \end{aligned}$$

In embodiments, in the second case generated in the battery model generating unit, the first resistance may be 0, and the second resistance may have a value obtained by reflecting a distribution status of lithium in the positive electrode active material of the LFP battery, which changes depending on the SOC, in the drop resistance as a resistance value.

In embodiments, when the drop resistance is R_vdrop(soc, c-rate, temp), the closest lithium distribution starting point from the peripheral portion in the positive electrode active material of the LFP battery according to the SOC is K_a(soc), and the closest lithium distribution end point from the peripheral portion in the positive electrode active material of the LFP battery the moment charging starts after a discharge state or a rest state after discharging is K_b_captured, the second resistance R_b may be calculated by the following equation.

[Equation]

$$R_b = (K_a(soc)/K_b_captured)) \times R_vdrop(soc,\ c\text{-}rate,\ temp)$$

In embodiments, the battery model generating unit may generate a battery model of the LFP battery by dividing the state of the lithium into a third case in which lithium is not distributed in a peripheral portion of the positive electrode active material of the LFP battery when discharging the LFP battery and a fourth case in which lithium is distributed in a peripheral portion of the positive electrode active material of the LFP battery when discharging the LFP battery.

In embodiments, in the fourth case generated in the battery model generating unit, the first resistance may be 0, and the second resistance may be a drop resistance considering a voltage difference between a voltage of the LFP battery measured according to at least one of a state of charge (SOC), a charge and discharge rate (c-rate) and a temperature, and an open circuit voltage (OCV) according to the SOC and the temperature.

In embodiments, when the drop resistance is R_vdrop(soc, c-rate, temp), the voltage of the LFP battery measured according to at least one of an SOC, a charge and discharge rate and a temperature is V_measurement (soc, c-rate, temp), the OCV according to at least one of the SOC and the temperature is V_ocv_ch(soc, temp), and a current flowing through the drop resistance according to the charge and discharge rate is I_c-rate, the second resistance R_b may be calculated by the following equation.

[Equation]

$$\begin{aligned} R_b &= R_vdrop(soc,\ c\text{-}rate,\ temp) \\ &= (V_measurement(soc,\ c\text{-}rate,\ temp) - V_ocv_ch(soc,\ temp))/I_c\text{-}rate \end{aligned}$$

In embodiments, in the third case generated in the battery model generating unit, the first resistance may have a value obtained by reflecting a distribution status of lithium in the positive electrode active material of the LFP battery, which

changes depending on the SOC, in the drop resistance as a resistance value, and the second resistance may be 0.

In embodiments, when the drop resistance is R_vdrop(soc, c-rate, temp), the closest lithium distribution end point from the peripheral portion in the positive electrode active material of the LFP battery according to the SOC is K_b(soc), the closest lithium distribution starting point from the peripheral portion in the positive electrode active material of the LFP battery the moment discharging starts after a charge state or a rest state after charging is K_a_captured, the first resistance R_a may be calculated by the following equation.

[Equation]

$$R_a = (K_b(soc)/K_a_captured)) \times R_vdrop(soc, c\text{-}rate, temp)$$

A method for generating an LFP battery model according to embodiments of the present disclosure includes: a lithium state recording step of recording a state of lithium (Li) in a positive electrode active material of a lithium iron phosphate ($LiFePO_4$, LFP) battery according to charging or discharging of the LFP battery in a lithium state recording unit; and a battery model generating step of generating a battery model of the LFP battery based on the recorded state of lithium in the positive electrode active material in a battery model generating unit, wherein the battery model generating step may include a step of generating a battery model by modeling the LFP battery with multiple resistors and capacitors reflecting the state of lithium in the positive electrode active material.

In embodiments, the lithium state recording step may include a step of recording a distribution state of lithium from a peripheral portion to a center in the positive electrode active material of the LFP battery, which changes depending on charging or discharging of the LFP battery.

In embodiments, the battery model generating step may include a step of generating a battery model of the LFP battery in a form of including a first resistance and a second resistance in an equivalent circuit model (ECM).

In embodiments, the battery model generating step may further include a step of generating a battery model of the LFP battery by dividing the state of the lithium into a first case in which lithium is not distributed in a peripheral portion of the positive electrode active material of the LFP battery when charging the LFP battery and a second case in which lithium is distributed in a peripheral portion of the positive electrode active material of the LFP battery when charging the LFP battery.

In embodiments, in the first case generated in the battery model generating step, the first resistance may be a drop resistance considering a voltage difference between a voltage of the LFP battery measured according to at least one of a state of charge (SOC), a charge and discharge rate (c-rate) and a temperature, and an open circuit voltage (OCV) according to at least one of the SOC and the temperature, and the second resistance may be 0. In the second case generated in the battery model generating step, the first resistance may be 0, and the second resistance may have a value obtained by reflecting a distribution status of lithium in the positive electrode active material of the LFP battery, which changes depending on the SOC, in the drop resistance as a resistance value.

In embodiments, the battery model generating step may further include a step of generating a battery model of the LFP battery by dividing the state of the lithium into a third case in which lithium is not distributed in a peripheral portion of the positive electrode active material of the LFP battery when discharging the LFP battery and a fourth case in which lithium is distributed in a peripheral portion of the positive electrode active material of the LFP battery when discharging the LFP battery.

In embodiments, in the fourth case generated in the battery model generating step, the first resistance may be 0, and the second resistance may be a drop resistance considering a voltage difference between a voltage of the LFP battery measured according to at least one of a state of charge (SOC), a charge and discharge rate (c-rate) and a temperature, and an open circuit voltage (OCV) according to at least one of the SOC and the temperature. In the third case generated in the battery model generating step, the first resistance may have a value obtained by reflecting a distribution status of lithium in the positive electrode active material of the LFP battery, which changes depending on the SOC, in the drop resistance as a resistance value, and the second resistance may be 0.

According to embodiments of the present disclosure, by recording a state of lithium (Li) in positive electrode active material of a lithium iron phosphate ($LiFePO_4$, LFP) battery according to charging or discharging of the LFP battery and generating a battery model of the LFP battery based on the recorded state of lithium in the positive electrode active material, the state of lithium in the positive electrode active material changing depending on the history of previous charging and discharging paths can be recorded, how internal resistance varies depending on the current positive electrode internal state in which the history of previous charging and discharging paths is reflected can be defined, and these may be ultimately applied to a battery model.

According to embodiments of the present disclosure, by generating a battery model through reflecting the internal state in the positive electrode active material, which changes depending on the history of previous charging and discharging paths, accuracy may increase by reducing errors in the battery model, and accordingly, errors in the state of charge (SOC) and the state of health (SOH) of the battery calculated from BMS can be reduced.

However, aspects and features of the present disclosure are not limited to those described herein, and other aspects and features not mentioned will be clearly understood by a person skilled in the art from the detailed description, described herein.

At least some of the above and other features of the invention are set out in the claims.

## BRIEF DESCRIPTION OF THE DRAWINGS

The following drawings attached to the present specification illustrate embodiments of the present disclosure, and further describe aspects and features of the present disclosure together with the detailed description of the present disclosure. Thus, the present disclosure should not be construed as being limited to the drawings:

FIG. 1 is a schematic diagram illustrating a cylindrical lithium secondary battery according to embodiments;
FIG. 2 is a schematic diagram illustrating a prismatic lithium secondary battery according to embodiments;
FIGS. 3 and 4 are schematic diagrams each illustrating a pouch-type lithium secondary battery according to embodiments;
FIG. 5 shows a battery model embodied in a comparative ECM (equivalent circuit model) manner;
FIG. 6 is a diagram illustrating an example of a resistance value that varies depending on a charging path of an LFP battery;
FIG. 7 is a diagram schematically illustrating an apparatus for generating an LFP battery model according to embodiments of the present disclosure;
FIG. 8 is a diagram for describing a method in which a lithium state recording unit of an apparatus for generating an LFP battery model according to embodiments of the present disclosure records a state of lithium in a positive electrode active material of an LFP battery;
FIG. 9 shows an example in which a lithium state recording unit of an apparatus for generating an LFP battery model according to embodiments of the present disclosure records a state of lithium in a positive electrode active material of an LFP battery;
FIG. 10 is a diagram for describing examples in which a lithium state recording unit of an apparatus for generating an LFP battery model according to embodiments of the present disclosure records a state of lithium in a positive electrode active material of an LFP battery when charging the LFP battery;
FIG. 11 is a diagram for describing examples in which a lithium state recording unit of an apparatus for generating an LFP battery model according to embodiments of the present disclosure records a state of lithium in a positive electrode active material of an LFP battery when discharging the LFP battery;
FIG. 12 is a diagram illustrating an example of a battery model generated by a battery model generating unit of an apparatus for generating an LFP battery model according to embodiments of the present disclosure;
FIGS. 13 and 14 are diagrams for describing examples in which a battery model generating unit of an apparatus for generating an LFP battery model according to embodiments of the present disclosure generates a battery model based on a state of lithium in a positive electrode active material of an LFP battery recorded by a lithium state recording unit when charging the LFP battery;
FIGS. 15 and 16 are diagrams for describing examples in which a battery model generating unit of an apparatus for generating an LFP battery model according to embodiments of the present disclosure generates a battery model based on a state of lithium in a positive electrode active material of an LFP battery recorded by a lithium state recording unit when discharging the LFP battery; and
FIG. 17 is a flowchart for describing a method for generating an LFP battery model according to embodiments of the present disclosure.

## DETAILED DESCRIPTION

Example embodiments of the present disclosure will be described herein in detail with reference to the accompanying drawings. Since the embodiments described in this specification and the configurations illustrated in the drawings are only an example of the present disclosure and they do not cover all the technical ideas of the present disclosure, it should be understood that various changes and modifications may be made at the time of filing this application.

It will be further understood that the terms "comprises/includes" and/or "comprising/including" when used herein, specify the presence of stated features, integers, steps, operations, elements, components, and/or groups thereof, but do not preclude the presence or addition of one or more other features, integers, steps, operations, elements, components, and/or groups thereof.

In order to facilitate understanding of the present disclosure, the accompanying drawings are not drawn to scale and the dimensions of some components may be exaggerated. It should be noted that the same reference numerals are

designated to the same components in different embodiments.

Reference to two compared elements, features, etc. as being "the same" means that they are "substantially the same". Therefore, the phrase "substantially the same" may include a deviation that is considered low in the art, for example, a deviation of 5% or less. The uniformity of any parameter in a given region may mean that it is uniform from an average perspective.

Although the terms such as "first" and/or "second" are used to describe various components, these components are not limited by these terms, of course. These terms are only used to distinguish one component from another component. Thus, unless specifically stated to the contrary, a first component may be termed a second component without departing from the teachings of example embodiments.

Throughout the specification, unless otherwise stated, each element may be singular or plural.

Arrangement of any component "above (or below)" or "on (or under)" a component may mean that any component is disposed in contact with the upper (or lower) surface of the component, as well as that other components may be interposed between the element and any element disposed on (or under) the element.

It will be understood that, when a component is referred to as being "connected", "coupled", or "joined" to another component, not only can it be directly "connected", "coupled", or "joined" to the other element, but also can it be indirectly "connected", "coupled", or "joined" to the other element with other elements interposed therebetween.

As used herein, the term "and/or" includes any and all combinations of one or more of the associate listed items. The use of "may" when describing embodiments of the present disclosure relates to "one or more embodiments of the present disclosure". Expressions such as "at least one" and "one or more" preceding a list of elements modify the entire list of elements and do not modify the individual elements in the list.

Throughout the specification, when "A and/or B" is stated, it means A, B, or A and B, unless otherwise stated. In addition, when "C to D" is stated, it means C or more and D or less, unless specifically stated to the contrary.

When the phrase such as "at least one of A, B, and C", "at least one of A, B, or C", "at least one selected from the group of A, B, and C", or "at least one selected from among A, B, and C" is used to designate a list of elements A, B, and C, the phrase may refer to any and all suitable combinations.

The term "use" may be considered synonymous with the term "utilize". As used herein, the terms "substantially," "about," and similar terms are used as terms of approximation rather than as terms of degree, and are intended to account for inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Accordingly, a first element, component, region, layer, or section discussed herein may be termed a second element, component, region, layer, or section without departing from the teachings of example embodiments.

For ease of explanation in describing the relationship of one element or feature to another element(s) or feature(s) as illustrated in the drawings, spatially relative terms such as "beneath", "below", "lower", "above", and "upper" may be used herein. It will be understood that spatially relative positions are intended to encompass different directions of the device in use or operation in addition to the direction depicted in the drawings. For example, if the device in the drawings is turned over, any element described as being "below" or "beneath" another element would then be oriented "above" or "over" another element. Therefore, the term "below" may encompass both upward and downward directions.

The terminology used herein is for the purpose of describing embodiments of the present disclosure and is not intended to limit the present disclosure.

The type of secondary battery includes a coin type, a cylindrical type, a prismatic type, and a pouch type. Prior to a description of embodiments of the present disclosure, first, cylindrical and prismatic secondary batteries are roughly described because the present disclosure may be basically applied to the cylindrical and prismatic secondary batteries.

FIGS. 1 to 4 are schematic diagrams illustrating lithium secondary batteries according to implementation examples. FIG. 1 may illustrate a cylindrical lithium secondary battery. FIG. 2 may illustrate a prismatic type secondary battery. FIGS. 3 and 4 may illustrate a pouch type secondary battery. Referring to FIG. 1 to 4, a lithium secondary battery 1 may include an electrode assembly 40 in which a separator 30 has been interposed between a first electrode plate 10 and a second electrode plate 20 and a case 50 in which the electrode assembly 40 has been embedded. The first electrode plate 10, the second electrode plate 20, and the separator 30 may be impregnated in an electrolyte (not illustrated). As illustrated in FIG. 1, the lithium secondary battery 1 may include a sealing member 60 that seals the case 50. Furthermore, in FIG. 2, the lithium secondary battery 1 may include a first electrode lead tab 11, a first electrode terminal 12, a second electrode lead tab 21, and a second electrode terminal 22. As illustrated in FIGS. 3 and 4, the lithium secondary battery 1 may include an electrode tab 70 that plays a role as an electrical passage for inducing a current formed in the electrode assembly 40 toward the outside, that is, a first electrode tab 71 and a second electrode tab 72.

The electrode assembly 40 may be formed by winding or stacking a stack body including the first electrode plate 10, the second electrode plate 20, and the separator 30 each of which is formed in a plate or film shape. In the case of the

winding stack body, the winding axis of the electrode assembly 40 may be parallel to the length direction of the case. Furthermore, the electrode assembly 40 may be the stack type not the winding type, but a shape of the electrode assembly 40 is not limited in embodiments of the present disclosure. The first electrode plate 10 of the electrode assembly 40 may play a role as a positive electrode, and the second electrode plate 20 thereof may play a role as a negative electrode, and vice versa.

The first electrode plate 10 may be formed by applying a first electrode active material, such as graphite or carbon, to a first electrode collector plate formed of metal foil, such as copper, a copper alloy, nickel, or a nickel alloy, and may include a first electrode tab (or a first uncoated part), that is, an area to which the first electrode active material has not been applied.

The second electrode plate 20 may be formed by applying a second electrode active material, such as transition metal oxide, to a material formed of metal foil, such as aluminum or an aluminum alloy, and may include a second electrode tab (or a second uncoated part), that is, an area to which the second electrode active material has not been applied.

The separator 30 may function to prevent a short-circuit between the first electrode plate 10 and the second electrode plate 20 while permitting a movement of lithium ions. The separator 30 may be composed of a polyethylene film, a polypropylene film, or a polyethylene-polypropylene film, for example.

The plurality of secondary batteries that has been described by taking FIGS. 1 to 4 as examples may be gathered to constitute a plurality of battery cells and accommodated in a battery case. A battery case according to embodiments of the present disclosure may include a support part that supports a hook after the hook and a hook hole are fastened, and can maintain the state in which the hook and the hook hole have been fastened because the breakaway of the hook attributable to the retreat of the hook can be prevented when an impact is applied to a battery pack. Hereinafter, a battery case according to embodiments of the present disclosure and a method of manufacturing the battery case are described with reference to drawings.

FIG. 5 shows a battery model embodied in an ECM (equivalent circuit model) according to a comparative example which does not implement aspects of the present disclosure.

Referring to FIG. 5, the comparative battery model may be expressed as a series resistance ($R_s$) for simulating a voltage drop when connecting a load and a voltage rise when charging, and a parallel resistance ($R_p$) and a parallel capacitor ($C_p$) for simulating a dynamic voltage response of a battery immediately after the voltage drop. Since a comparative ternary system does not have path dependency, resistance and capacitor values in the model do not need to include previous charging and discharging history, and therefore, a battery may be sufficiently simulated with the comparative ECM-type battery model.

However, as a unique property of an LFP battery, an internal resistance value varies depending on charging and discharging paths of the battery. For example, when an LFP battery in a state of charge (SOC) of 100% is discharged to be in an SOC of 50% and when an LFP battery in an SOC of 0% is charged to be in an SOC of 50%, the LFP batteries in the two cases have the same SOC value of 50%, but have different charging and discharging paths to reach the SOC of 50%, leading to a difference in the distribution of lithium (Li) ions in a positive electrode active material, and this difference in the distribution causes a difference in the internal resistance value, and as a result, different internal resistance values are obtained.

Accordingly, when a battery model embodied in the comparative ECM manner is used for an LFP battery, there is a problem in that, when parameters of a series resistance ($R_s$), a parallel resistance ($R_p$) and a parallel capacitor ($C_p$) are set based on specific charging and discharging paths, all differences in internal resistance values caused by other charging or discharging paths appear as errors.

FIG. 6 is a diagram illustrating an example of a resistance value that varies depending on a charging path of an LFP battery.

Referring to FIG. 6, graphs showing changes in the voltage over time are shown for the case where the SOC increases from 40% to 60%, the case where the SOC decreases from 45% to 40% and then increases again to 60%, and the case where the SOC decreases from 50% to 40% and then increases again to 60%.

As illustrated in FIG. 6, the voltage shows the steepest increase when the SOC increases from 40% to 60%, the voltage shows somewhat more gradual increase when the SOC decreases from 45% to 40% and then increases again to 60%, and the voltage shows the most gradual increase when the SOC decreases from 50% to 40% and then increases again to 60%.

This is due to the fact that the internal resistance value differs depending on the charging and discharging paths of an LFP battery, and this difference causes a difference in the graph of voltage rise. Accordingly, the comparative battery model of FIG. 5 has a problem in that even when the parameters are set based on the graph of any charging and discharging paths, errors occur in all charging and discharging paths of the remaining cases.

Accordingly, when attempting to apply an ECM model to an LFP battery, it is necessary to supplement parameters reflecting charging and discharging paths of the LFP battery. According to an apparatus and a method for generating an LFP battery model according to embodiments of the present disclosure, an internal resistance value that varies depending on the charging and discharging paths may all be reflected in the battery model, and therefore, it is

possible to generate a battery model regardless of which charging and discharging paths are followed in the three graphs of FIG. 6. As a result, accuracy may increase by reducing errors in the battery model.

FIG. 7 is a diagram schematically illustrating an apparatus for generating an LFP battery model according to embodiments of the present disclosure.

Referring to FIG. 7, the apparatus for generating an LFP battery model 100 according to embodiments of the present disclosure may include a lithium state recording unit 110 and a battery model generating unit 120. In embodiments, the apparatus for generating an LFP battery model 100 according to embodiments of the present disclosure may be included in a battery management system (BMS) to generate a battery model of an LFP battery 1.

The lithium state recording unit 110 records a state of lithium in a positive electrode active material of the LFP battery 1 according to charging or discharging of the LFP battery 1.

The battery model generating unit 120 generates a battery model of the LFP battery 1 based on the recorded state of lithium in the positive electrode active material. In embodiments, the battery model generating unit 120 generates a battery model by modeling the LFP battery with multiple resistors and capacitors reflecting the state of lithium in the positive electrode active material.

Hereinafter, examples of specific methods in which the lithium state recording unit 110 records a state of lithium in a positive electrode active material of the LFP battery 1, and the battery model generating unit 120 generates a battery model of the LFP battery 1 based on the recorded state of lithium in the positive electrode active material will be described with reference to the drawings.

FIG. 8 is a diagram for describing a method in which the lithium state recording unit of the apparatus for generating an LFP battery model according to embodiments of the present disclosure records a state of lithium in a positive electrode active material of the LFP battery.

Referring to FIG. 8, the positive electrode active material of the LFP battery is illustrated, and the left portion in the drawing illustrates the positive electrode active material in the case where charging is performed from a fully discharged state, that is, an SOC of 0%, to an SOC of 50%, and the right portion in the drawing illustrates the positive electrode active material in the case where discharging is performed from a fully charged state, that is, an SOC of 100%, to an SOC of 50%.

The positive electrode active material repeatedly goes through LFP state and FP state as the charging or discharging progresses, and this may be expressed by the following chemical formula.

【Chemical Formula 1】

$$\mathbf{Li_xFePO_4 \leftrightarrow Li_yFePO_4 + (x-y)\,Li^+ + (x-y)\,e^-}$$

**(LFP)** **(FP)**

By the chemical reaction as shown in the Chemical Formula, Li+ ions flow out from the peripheral portion of the positive electrode active material to a negative electrode when charging from a fully discharged state as shown on the left side of FIG. 8. Herein, the boundary between the peripheral FP and the inner LFP moves from the peripheral portion to the center.

When discharging from a fully charged state as shown on the right side of FIG. 8, Li+ ions are pushed into a positive electrode from the peripheral portion of the positive electrode active material. Herein, the boundary between the peripheral LFP and the inner FP moves from the peripheral portion to the center.

Such a state of lithium in the positive electrode active material, that is, changes in the lithium distribution, may be shown as a one-dimensional bar graph expressing from the peripheral portion to the center of the positive electrode active material. For example, looking into the case of being discharged from a fully charged state on the right side of FIG. 8 shown as a bar graph at the bottom of FIG. 8, the boundary between the peripheral LFP and the inner FP moves from the peripheral portion to the center when lithium is introduced from the peripheral portion, and the side closer to the peripheral portion on the left becomes a rich phase with abundant lithium, and the side closer to the inside on the right becomes a poor phase with almost no lithium.

Herein, the lithium being distributed on the peripheral portion means that, when modeling the positive electrode active material particles, lithium ions are accumulated from the positive electrode active material particle surface, forming a layer close to the particle surface. By the role of this layer, lithium close to the particle surface readily flows out during charging, and it is difficult for the particles to readily flow in during discharging by the lithium close to the particle surface.

FIG. 9 is an example in which the lithium state recording unit of the apparatus for generating an LFP battery model according to embodiments of the present disclosure records a state of lithium in the positive electrode active material of the LFP battery.

Referring to FIG. 9, an example of a bar graph is illustrated, in which the lithium state recording unit of the apparatus for generating an LFP battery model according to embodiments of the present disclosure records a state of

lithium in the positive electrode active material of the LFP battery using the method of FIG. 8.

As described above in FIG. 8, when Li+ ions flow out from the peripheral portion of the positive electrode active material to a negative electrode during charging from a fully discharged state, the boundary between the peripheral FP and the inner LFP moves from the peripheral portion to the center, and when Li+ ions are pushed into a positive electrode from the peripheral portion of the positive electrode active material during discharging from a fully charged state, the boundary between the peripheral LFP and the inner FP moves from the peripheral portion to the center.

Such charging and discharging processes are recorded through the SOC of the battery. Herein, the position where the lithium ions start may be expressed as P_S as a point start, and the position where the lithium ions end may be expressed as P_E as a point end. An internal layer may be formed according to this history of charging and discharging, and in order to express such layer information, P_S and P_E may use multiple arrangements as illustrated in FIG. 9.

Since the rich (beta) phase and the poor (alpha) phase coexist in the positive electrode active material, the internal state is simulated only in the region with flat voltage (approximately SOC 10% to 90%). However, for convenience, the simulation may be conducted in the same manner in other regions as well, and when applying it to the model, the corresponding algorithm may be reflected only in the region with flat voltage in the positive electrode active material.

FIG. 10 is a diagram for describing examples in which the lithium state recording unit of the apparatus for generating an LFP battery model according to embodiments of the present disclosure records a state of lithium in the positive electrode active material of the LFP battery when charging the LFP battery.

Referring to FIG. 10, the state of lithium in the positive electrode active material of the LFP battery when charging the LFP battery is illustrated. When charging the LFP battery, Li+ ions flow out through the peripheral portion of the positive electrode active material to a negative electrode, and therefore, the boundary between FP and LFP moves to the center.

In (a) of FIG. 10, the peripheral portion is in a poor phase after charging from the SOC of 30% to the SOC of 40% as shown on the right, and therefore, internal resistance is high since Li+ ions located on the inside need to pass through the poor phase to flow out when charging to the SOC of 100%.

In (c) of FIG. 10, a rich phase remains on the peripheral portion after discharging from the SOC of 100% to the SOC of 40% as shown on the right, and therefore, internal resistance is low since Li+ ions may flow out immediately from the peripheral portion when charging to the SOC of 50%.

In (b) of FIG. 10, a rich phase remains on the peripheral portion after discharging from the SOC of 50% to the SOC of 40% as shown on the right, however, the rich phase is less compared to in the case of (c), and therefore, when charging to the SOC of 50%, resistance gradually increases until all Li+ ions flow out from the most peripheral portion in the rich phase. Herein, internal resistance is related to the thickness of the most peripheral portion in the rich phase.

FIG. 11 is a diagram for describing examples in which the lithium state recording unit of the apparatus for generating an LFP battery model according to embodiments of the present disclosure records a state of lithium in the positive electrode active material of the LFP battery when discharging the LFP battery.

Referring to FIG. 11, the state of lithium in the positive electrode active material of the LFP battery when discharging the LFP battery is illustrated. When discharging the LFP battery, Li+ ions flow in from a negative electrode through the peripheral portion of the positive electrode active material, and therefore, the boundary between LFP and FP moves to the center.

In (a) of FIG. 11, the peripheral portion is in a rich phase after discharging from the SOC of 60% to the SOC of 50% as shown on the right, and therefore, internal resistance is high since Li+ ions located on the peripheral portion need to pass through the rich phase to flow in when discharging to the SOC of 0%.

In (c) of FIG. 11, there is a poor phase on the peripheral portion after charging from the SOC of 0% to the SOC of 50% as shown on the right, and therefore, internal resistance is low since Li+ ions may flow in immediately from the peripheral portion and settle down immediately when discharging to the SOC of 40%.

In (b) of FIG. 11, a poor phase remains on the peripheral portion after charging from the SOC of 40% to the SOC of 50% as shown on the right, however, the poor phase is less compared to in the case of (c), and therefore, when discharging to the SOC of 40%, resistance gradually increases until Li+ ions fully occupy the most peripheral portion in the poor phase. Herein, internal resistance is related to the thickness of the most peripheral portion in the poor phase.

As described herein, the lithium state recording unit 110 of the apparatus for generating an LFP battery model 100 according to embodiments of the present disclosure may record the state of lithium in the positive electrode active material of the LFP battery 1 using the methods of FIGS. 8 to 11.

FIG. 12 is a diagram illustrating an example of a battery model generated by the battery model generating unit of the apparatus for generating an LFP battery model according to embodiments of the present disclosure.

Referring to FIG. 12, the battery model generating unit 110 of the apparatus for generating an LFP battery model 100 according to embodiments of the present disclosure may generate a battery model of the LFP battery in the form of including a first resistance ($R_a$) and a second resistance ($R_b$) in an equivalent circuit model (ECM). In other words, in a battery model generated using a comparative ECM method, a parallel resistance ($R_p$) and a parallel capacitor ($C_P$) are left as they are maintained, and a series resistance ($R_s$) may be replaced by a first resistance (R_a) and a second resistance (R _b).

Herein, the first resistance (R_a) represents a resistance component produced by being distant from the first lithium ion layer when viewed from the lithium surface, and the second resistance (R_b) means a resistance component produced as the thickness of the first lithium ion layer on the surface changes.

Herein, resistance values of the first resistance (R_a) and the second resistance (R_b) calculated by the battery model generating unit 110 may change depending on charging or discharging, and hereinafter, a method of calculating the resistance values of the first resistance (R_a) and the second resistance (R_b) will be described.

FIGS. 13 and 14 are diagrams for describing examples in which the battery model generating unit of the apparatus for generating an LFP battery model according to embodiments of the present disclosure generates a battery model based on the state of lithium in the positive electrode active material of the LFP battery recorded by the lithium state recording unit when charging the LFP battery.

Referring to FIGS. 13 and 14, the battery model generating unit 110 may generate a battery model of the LFP battery by dividing the state of the lithium into a first case in which lithium is not distributed on the peripheral portion of the positive electrode active material of the LFP battery 1 when charging the LFP battery 1 and a second case in which lithium is distributed on the peripheral portion of the positive electrode active material of the LFP battery 1 when charging the LFP battery 1.

The first case is a case in which lithium flows out due to previous charging, leaving no lithium on the peripheral portion of the positive electrode active material, and the second case is a case in which lithium flows in due to previous discharging, having lithium accumulated on the peripheral portion of the positive electrode active material. Such lithium distribution is maintained regardless of whether there is a rest between the previous state and the current state.

As illustrated in FIG. 13, internal resistance is high in the first case since, when charging is conducted starting from the SOC of 40% to the SOC of 50% via the SOC of 45% with no lithium on the peripheral portion of the positive electrode active material, lithium ions on the inside need to pass through the poor phase to flow out. Herein, as illustrated in FIG. 14, the upper part of the graph of the first case may be considered as a contribution of the first resistance (R_a). In such a first case, the first resistance (R_a) may be a drop resistance considering a voltage difference between a voltage of the LFP battery measured according to at least one of the SOC, the charge and discharge rate (c-rate) and a temperature, and an open circuit voltage (OCV) according to at least one of the SOC and the temperature, and the second resistance (R_b) may be 0.

In embodiments, when the drop resistance is R_vdrop(soc, c-rate, temp), the voltage of the LFP battery 1 measured according to at least one of the SOC, the charge and discharge rate and a temperature is V_measurement(soc, c-rate, temp), the OCV according to at least one of the SOC and the temperature is V_ocv_ch(soc, temp), and a current flowing through the drop resistance according to the charge and discharge rate is I_c-rate, the first resistance (R_a) may be calculated by the following equation.

【Equation 1】

$$R_a = R_vdrop(soc, c\text{-}rate, temp) = (V_measurement(soc, c\text{-}rate, temp) - V_ocv_ch(soc, temp))/I_c\text{-}rate$$

As illustrated in FIG. 13, in the second case, when charging is conducted starting from the SOC of 40% to the SOC of 50% via the SOC of 45% with lithium accumulated on the peripheral portion of the positive electrode active material, lithium ions of the peripheral portion may flow out immediately from the peripheral portion, and internal resistance gradually increases until all lithium ions flow out from the most peripheral portion in the rich phase. Herein, as illustrated in FIG. 14, the upper part of the graph of the second case may be considered as a contribution of the second resistance (R_b). In such a second case, the first resistance (R_a) may be 0, and the second resistance (R_b) may have a value obtained by reflecting the distribution status of lithium in the positive electrode active material of the LFP battery, which changes depending on the SOC, in the drop resistance as a resistance value.

In embodiments, when the drop resistance is R_vdrop(soc, c-rate, temp), the closest lithium distribution starting point from the peripheral portion in the positive electrode active material of the LFP battery 1 according to the SOC is K_a(soc), and the closest lithium distribution end point from the peripheral portion in the positive electrode active material of the LFP battery 1 the moment charging starts after a discharge state or a rest state after discharging is K_b_captured, the second resistance (R_b) may be calculated by the following equation.

【Equation 2】

$$R_b = (K_a(soc)/K_b_captured)) \times R_vdrop(soc, c\text{-}rate, temp)$$

FIGS. 15 and 16 are diagrams for describing examples in which the battery model generating unit of the apparatus for generating an LFP battery model according to embodiments of the present disclosure generates a battery model based on the state of lithium in the positive electrode active material of the LFP battery recorded by the lithium state recording unit when discharging the LFP battery.

Referring to FIGS. 15 and 16, the battery model generating unit 110 may generate a battery model of the LFP battery by dividing the state of the lithium into a third case in which lithium is not distributed on the peripheral portion of the positive electrode active material of the LFP battery 1 when discharging the LFP battery 1 and a fourth case in which lithium is distributed on the peripheral portion of the positive electrode active material of the LFP battery 1 when discharging the LFP battery 1.

The third case is a case in which lithium flows out due to previous charging, leaving no lithium on the peripheral portion of the positive electrode active material, and the fourth case is a case in which lithium flows in due to previous discharging, having lithium accumulated on the peripheral portion of the positive electrode active material. Such lithium distribution is maintained regardless of whether there is a rest between the previous state and the current state.

As illustrated in FIG. 15, internal resistance is high in the fourth case since, when discharging is conducted starting from the SOC of 40% to the SOC of 30% via the SOC of 35% with lithium accumulated on the peripheral portion of the positive electrode active material, lithium ions located on the peripheral portion need to pass through the rich phase to flow in. Herein, as illustrated in FIG. 16, the lower part of the graph of the fourth case may be considered as a contribution of the second resistance (R _b). In such a fourth case, the first resistance (R_a) may be 0, and the second resistance (R_b) may be a drop resistance considering a voltage difference between a voltage of the LFP battery measured according to at least one of the SOC, the charge and discharge rate and a temperature, and an OCV according to at least one of the SOC and the temperature.

In embodiments, when the drop resistance is R_vdrop(soc, c-rate, temp), the voltage of the LFP battery 1 measured according to at least one of the SOC, the charge and discharge rate and a temperature is V_measurement(soc, c-rate, temp), the OCV according to at least one of the SOC and the temperature is V_ocv_ch(soc, temp), and a current flowing through the drop resistance according to the charge and discharge rate is I_c-rate, the second resistance (R_b) may be calculated by the following equation.

【Equation 3】

$$\begin{aligned} R_b &= R_vdrop(soc,\ c\text{-}rate,\ temp) \\ &= (V_measurement(soc,\ c\text{-}rate,\ temp) - V_ocv_ch(soc,\ temp))/I_c\text{-}rate \end{aligned}$$

As illustrated in FIG. 15, in the third case, when discharging is conducted starting from the SOC of 50% to the SOC of 40% via the SOC of 45% with no lithium on the peripheral portion of the positive electrode active material, lithium ions of the peripheral portion may flow in from the peripheral portion and settle down immediately, and therefore, resistance gradually increases until lithium ions fully occupy the most peripheral portion in the poor phase. Herein, as illustrated in FIG. 16, the lower part of the graph of the third case may be considered as a contribution of the first resistance (R_a). In such a third case, the first resistance (R_a) may have a value obtained by reflecting the distribution status of lithium in the positive electrode active material of the LFP battery, which changes depending on the SOC, in the drop resistance as a resistance value, and the second resistance (R_b) may be 0.

In embodiments, when the drop resistance is R_vdrop(soc, c-rate, temp), the closest lithium distribution end point from the peripheral portion in the positive electrode active material of the LFP battery 1 according to the SOC is K_b(soc), the closest lithium distribution starting point from the peripheral portion in the positive electrode active material of the LFP battery 1 the moment discharging starts after a charge state or a rest state after charging is K_a_captured, the first resistance (R_a) may be calculated by the following equation.

【Equation 4】

$$R_a = (K_b(soc)/K_a_captured)) \times R_vdrop(soc,\ c\text{-}rate,\ temp)$$

According to embodiments of the present disclosure, by recording a state of lithium in the positive electrode active material of the LFP battery 1 according to charging or discharging of the LFP battery 1 and generating a battery model of the LFP battery 1 based on the recorded state of lithium in the positive electrode active material, the state of lithium in the positive electrode active material changing depending on the history of previous charging and discharging paths may be recorded, how internal resistance varies depending on the current positive electrode internal state in which the history of

previous charging and discharging paths is reflected may be defined, and these may be ultimately applied to a battery model.

According to embodiments of the present disclosure, by generating a battery model through reflecting the internal state in the positive electrode active material, which changes depending on the history of previous charging and discharging paths, accuracy may increase by reducing errors in the battery model, and accordingly, errors in the state of charge (SOC) and the state of health (SOH) of the battery calculated from BMS may be reduced.

FIG. 17 is a flowchart for describing a method for generating an LFP battery model according to embodiments of the present disclosure.

Referring to FIG. 17, the method for generating an LFP battery model according to embodiments of the present disclosure may include steps S210 to S220.

Step S210 is a step of recording a state of lithium (Li) in a positive electrode active material of a lithium iron phosphate ($LiFePO_4$, LFP) battery according to charging or discharging of the LFP battery in a lithium state recording unit. In embodiments, step S210 may include a step of recording a distribution state of lithium from the peripheral portion to the center in the positive electrode active material of the LFP battery, which changes depending on charging or discharging of the LFP battery.

Step S220 is a battery model generating step of generating a battery model of the LFP battery based on the recorded state of lithium in the positive electrode active material in a battery model generating unit. In embodiments, step S220 may include a step of generating a battery model by modeling the LFP battery with multiple resistors and capacitors reflecting the state of lithium in the positive electrode active material.

In embodiments, step S220 may include a step of generating a battery model of the LFP battery in a form of including a first resistance and a second resistance in an equivalent circuit model (ECM).

In embodiments, step S220 may further include a step of generating a battery model of the LFP battery by dividing the state of the lithium into a first case in which lithium is not distributed on the peripheral portion of the positive electrode active material of the LFP battery when charging the LFP battery and a second case in which lithium is distributed on the peripheral portion of the positive electrode active material of the LFP battery when charging the LFP battery.

In another embodiment, step S220 may further include a step of generating a battery model of the LFP battery by dividing the state of the lithium into a third case in which lithium is not distributed on the peripheral portion of the positive electrode active material of the LFP battery when discharging the LFP battery and a fourth case in which lithium is distributed on the peripheral portion of the positive electrode active material of the LFP battery when discharging the LFP battery.

The method for generating an LFP battery model according to embodiments of the present disclosure described herein has been described with reference to the flow chart presented in the drawing. The method has been illustrated and described with a series of blocks for simplicity, however, the present disclosure is not limited to the order of the blocks, and some blocks may be conducted in an order different from those illustrated and described in the present specification or simultaneously with other blocks, and various other branches, flow paths and block orders achieving the same or similar results may be embodied. In addition, all blocks illustrated for embodying the method described in the present specification may not be required.

Meanwhile, in the description referring to FIG. 17, each step may be further divided into additional steps or combined into fewer steps depending on embodiments of the present disclosure. In addition, some steps may not be included as necessary, and the order between the steps may also be changed. In addition, even for other descriptions that are not included, the descriptions provided with reference to FIG. 1 to 16 may be applied to the description provided with reference to FIG. 17. In addition, the description provided with reference to FIG. 17 may be applied to the descriptions provided with reference to FIGS. 1 to 16.

Hereinafter, materials which may be used in a secondary battery according to an embodiment of the present disclosure are described.

A compound (e.g., a lithiated intercalation compound) capable of reversible intercalation and deintercalation of lithium may be used as a positive electrode active material. Specifically, one type or more selected among complex oxides of metal, selected among cobalt, manganese, nickel, and a combination of them, and lithium may be used as the positive electrode active material.

The complex oxide may be lithium transition metal complex oxide. A detailed example of the complex oxide may include lithium nickel-based oxide, lithium cobalt-based oxide, lithium manganese-based oxide, a lithium ferrous phosphate-based compound, cobalt-free nickel-manganese-based oxide, or a combination of them.

For example, a compound that is represented as one of the following chemical formulas may be used. LiaA1-bXbO2-cDc (0.90≤a≤1.8, 0≤b≤0.5, 0≤c≤0.05); LiaMn2-bXbO4-cDc (0.90≤a≤1.8, 0≤b≤0.5, 0≤c≤0.05); LiaNi1-b-cCobXcO2-αDα (0.90≤a≤1.8, 0≤b≤0.5, 0≤c≤0.5, 0<α<2); LiaNi1-b-cMnbXcO2-αDα (0.90≤a≤1.8, 0≤b≤0.5, 0≤c≤0.5, 0<α<2); LiaNibCocL1dGeO2 (0.90≤a≤1.8, 0≤b≤0.9, 0≤c≤0.5, 0≤d≤0.5, 0≤e≤0.1); LiaNiGbO2 (0.90≤a≤1.8, 0.001≤b≤0.1); LiaCoGbO2 (0.90≤a≤1.8, 0.001≤b≤0.1); LiaMn1-bGbO2 (0.90≤a≤1.8, 0.001≤b≤0.1); LiaMn2GbO4 (0.90≤a≤1.8, 0.001≤b≤0.1); LiaMn1-gGgPO4 (0.90≤a≤1.8, 0≤g≤0.5); Li (3-f) Fe2 (PO4)3 (0≤f≤2); and LiaFePO4 (0.90≤a≤1.8).

In the chemical formula, A may be Ni, Co, Mn, or a combination of them. X may be Al, Ni, Co, Mn, Cr, Fe, Mg, Sr, V, a rare earth element, or a combination of them; D may be O, F, S, P, or a combination of them. G may be Al, Cr, Mn, Fe, Mg, La, Ce, Sr, V, or a combination of them. L1 may be Mn, Al, or a combination of them.

A positive electrode for a lithium secondary battery may include a current collector and a positive electrode active material layer formed on the current collector. The positive electrode active material layer may include the positive electrode active material, and may further include a binder and/or a conductive material.

Content of the positive electrode active material may be 90 wt.% to 99.5 wt.% with respect to the positive electrode active material layer 100 wt.%. Content of the binder and the conductive material may be 0.5 wt.% to 5 wt.% with respect to the positive electrode active material layer 100 wt.%.

Al may be used as the current collector, but the present disclosure may not be limited thereto.

A negative electrode active material may include a material capable of reversibly Intercalation/deintercalation with respect to lithium ions, lithium metal, an alloy of lithium metal, a material capable of doping and dedoping with respect to lithium, or transition metal oxide.

The material capable of reversibly Intercalation/deintercalation with respect to lithium ions may include a carbon-based negative electrode active material, for example, crystalline carbon, amorphous carbon, or a combination of them. An example of the crystalline carbon may include graphite, such as natural graphite or synthetic graphite. Examples of the amorphous carbon may include soft or hard carbon, mesophase pitch carbide, and fired coke.

An Si-based negative electrode active material or an Sn-based negative electrode active material may be used as the material capable of doping and dedoping with respect to lithium. The Si-based negative electrode active material may be silicon, a silicon-carbon composite, $SiO_x$ ($0<x<2$), a Si-based alloy, or a combination of them.

The silicon-carbon composite may be a composite of silicon and amorphous carbon. According to an implementation example, the silicon-carbon composite may include silicon particles, and may have a form in which amorphous carbon has been coated on surfaces of silicon particles.

The silicon-carbon composite may further include crystalline carbon. For example, the silicon-carbon composite may include a core including crystalline carbon and silicon particles, and an amorphous carbon coating layer disposed on a surface of the core.

A negative electrode for a lithium secondary battery may include a current collector and a negative electrode active material layer disposed on the current collector. The negative electrode active material layer may include the negative electrode active material, and may further include a binder and/or a conductive material.

For example the negative electrode active material layer may include the negative electrode active material of 90 wt.% to 99 wt.%, the binder of 0.5 wt.% to 5 wt.%, and the conductive material of 0 wt.% to 5 wt.%.

A nonaqueous-based binder, an aqueous-based binder, a dry binder, or a combination of them may be used as the binder. If the aqueous-based binder is used as a binder for the negative electrode, the binder for the negative electrode may further include a cellulose-series compound capable of assigning viscosity.

One selected among nickel foil, stainless steel foil, titanium foil, nickel foam, copper foam, a polymer base on which a conductive metal has been coated, and a combination of them may be used as a current collector for the negative electrode.

An electrolyte for a lithium secondary battery may include a nonaqueous organic solvent and lithium salts.

The nonaqueous organic solvent may play a role as a medium through which ions that are involved in an electrochemical reaction of a battery can move.

The nonaqueous organic solvent may be a carbonate-based, ester-based, ether-based, ketone-based, or alcohol-based solvent, an aprotic solvent, or a combination of them. The carbonate-based, ester-based, ether-based, ketone-based, or alcohol-based solvent, or the aprotic solvent may be used solely, or two types or more of them may be mixed and used as the nonaqueous organic solvent.

Furthermore, if the carbonate-based solvent is used, annular carbonate and chain carbonate may be mixed and used.

A separator may be present between the positive electrode and the negative electrode depending on the type of lithium secondary battery. Polyethylene, polypropylene, and polyvinylidene fluoride, or a multi-layer having two or more layers of them may be used as the separator.

The separator may include a porous base, and a coating layer including an organic matter, an inorganic matter, or a combination of them that is disposed on one or both sides of the porous base.

The organic matter may include a polyvinylidene fluoride-based heavy antibody or (meth)acrylic polymer.

The inorganic matter may include inorganic particles selected among $Al_2O_3$, $SiO_2$, $TiO_2$, $SnO_2$, $CeO_2$, MgO, NiO, CaO, GaO, ZnO, $ZrO_2$, $Y_2O_3$, $SrTiO_3$, $BaTiO_3$, $Mg(OH)_2$, boehmite, and a combination of them, but the present disclosure is not limited thereto.

The organic matter and the inorganic matter may have a form in which the organic matter and the inorganic matter have been mixed in one coating layer or a form in which a coating layer including the organic matter and a coating layer including the inorganic matter have been stacked

Although the present disclosure has been described herein in connection with the limited embodiments and drawings, the present disclosure is not limited to the embodiments but is defined in the appended claims.

Embodiments are set out in the following clauses:

1. An apparatus for generating a lithium iron phosphate ($LiFePO_4$, LFP) battery model, the apparatus comprising:

   a lithium state recording unit that records a state of lithium (Li) in positive electrode active material of an LFP battery according to charging or discharging of the LFP battery; and
   a battery model generating unit that generates a battery model of the LFP battery based on the recorded state of lithium in the positive electrode active material,
   wherein the battery model generating unit generates a battery model by modeling the LFP battery with multiple resistors and capacitors reflecting the state of lithium in the positive electrode active material.

2. The apparatus of clause 1, wherein the lithium state recording unit records a distribution state of lithium from a peripheral portion to a center in the positive electrode active material of the LFP battery, which changes depending on charging or discharging of the LFP battery.

3. The apparatus of clause 2, wherein the battery model generating unit generates a battery model of the LFP battery in a form including a first resistance and a second resistance in an equivalent circuit model (ECM).

4. The apparatus of clause 3, wherein the battery model generating unit generates a battery model of the LFP battery by dividing the state of the lithium into a first case in which lithium is not distributed in a peripheral portion of the positive electrode active material of the LFP battery when charging the LFP battery and a second case in which lithium is distributed in a peripheral portion of the positive electrode active material of the LFP battery when charging the LFP battery.

5. The apparatus of clause 4, wherein, in the first case generated in the battery model generating unit, the first resistance is a drop resistance considering a voltage difference between a voltage of the LFP battery measured according to at least one of a state of charge (SOC), a charge and discharge rate (c-rate) and a temperature, and an open circuit voltage (OCV) according to at least one of the SOC and the temperature, and the second resistance is 0.

6. The apparatus of clause 5, wherein, when the drop resistance is R_vdrop(soc, c-rate, temp), the voltage of the LFP battery measured according to at least one of an SOC, a charge and discharge rate and a temperature is V_measurement (soc, c-rate, temp), the OCV according to at least one of the SOC and the temperature is V_ocv_ch (soc, temp), and a current flowing through the drop resistance according to the charge and discharge rate is I_c-rate, the first resistance R_a is calculated by the following equation:

[Equation]

$$R_a = R_vdrop(soc, c\text{-}rate, temp) = (V_measurement(soc, c\text{-}rate, temp) - V_ocv_ch(soc, temp))/I_c\text{-}rate .$$

7. The apparatus of clause 6, wherein, in the second case generated in the battery model generating unit, the first resistance is 0, and the second resistance has a value obtained by reflecting a distribution status of lithium in the positive electrode active material of the LFP battery, which changes depending on the SOC, in the drop resistance as a resistance value.

8. The apparatus of clause 7, wherein, when the drop resistance is R_vdrop(soc, c-rate, temp), the closest lithium distribution starting point from the peripheral portion in the positive electrode active material of the LFP battery according to the SOC is K_a(soc), and the closest lithium distribution end point from the peripheral portion in the positive electrode active material of the LFP battery the moment charging starts after a discharge state or a rest state after discharging is K_b_captured, the second resistance R_b is calculated by the following equation:

[Equation]

$$R_b = (K_a(soc)/K_b_captured)) \times R_vdrop(soc, c\text{-}rate, temp).$$

9. The apparatus of any of clauses 3 to 8, wherein the battery model generating unit generates a battery model of the LFP battery by dividing the state of the lithium into a third case in which lithium is not distributed in a peripheral portion of the positive electrode active material of the LFP battery when discharging the LFP battery and a fourth case in which lithium is distributed in a peripheral portion of the positive electrode active material of the LFP battery when discharging the LFP battery.

10. The apparatus of clause 9, wherein, in the fourth case generated in the battery model generating unit, the first resistance is 0, and the second resistance is a drop resistance considering a voltage difference between a voltage of the LFP battery measured according to at least one of a state of charge (SOC), a charge and discharge rate (c-rate) and a temperature, and an open circuit voltage (OCV) according to at least one of the SOC and the temperature.

11. The apparatus of clause 10, wherein, when the drop resistance is R_vdrop(soc, c-rate, temp), the voltage of the LFP battery measured according to at least one of an SOC, a charge and discharge rate and a temperature is V_measurement (soc, c-rate, temp), the OCV according to at least one of the SOC and the temperature is V_ocv_ch (soc, temp), and a current flowing through the drop resistance according to the charge and discharge rate is I_c-rate, the second resistance R_b is calculated by the following equation:

[Equation]

$$R_b = R_vdrop(soc, c\text{-}rate, temp) = (V_measurement(soc, c\text{-}rate, temp) - V_ocv_ch(soc, temp))/I_c\text{-}rate.$$

12. The apparatus of clause 11, wherein, in the third case generated in the battery model generating unit, the first resistance has a value obtained by reflecting a distribution status of lithium in the positive electrode active material of the LFP battery, which changes depending on the SOC, in the drop resistance as a resistance value, and the second resistance is 0.

13. The apparatus of clause 12, wherein, when the drop resistance is R_vdrop(soc, c-rate, temp), the closest lithium distribution end point from the peripheral portion in the positive electrode active material of the LFP battery according to the SOC is K_b(soc), the closest lithium distribution starting point from the peripheral portion in the positive electrode active material of the LFP battery the moment discharging starts after a charge state or a rest state after charging is K_a_captured, the first resistance R_a is calculated by the following equation:

[Equation]

$$R_a = (K_b(soc)/K_a_captured)) \times R_vdrop(soc, c\text{-}rate, temp).$$

14. A method for generating a lithium iron phosphate ($LiFePO_4$, LFP) battery model, the method comprising:

a lithium state recording step of recording a state of lithium (Li) in positive electrode active material of an LFP battery according to charging or discharging of the LFP battery in a lithium state recording unit; and
a battery model generating step of generating a battery model of the LFP battery based on the recorded state of lithium in the positive electrode active material in a battery model generating unit,
wherein the battery model generating step includes a step of generating a battery model by modeling the LFP battery with multiple resistors and capacitors reflecting the state of lithium in the positive electrode active material.

15. The method of clause 14, wherein the lithium state recording step comprises a step of recording a distribution state of lithium from a peripheral portion to a center in the positive electrode active material of the LFP battery, which changes depending on charging or discharging of the LFP battery.

16. The method of clause 15, wherein the battery model generating step comprises a step of generating a battery

model of the LFP battery in a form including a first resistance and a second resistance in an equivalent circuit model (ECM).

17. The method of clause 16, wherein the battery model generating step further comprises a step of generating a battery model of the LFP battery by dividing the state of the lithium into a first case in which lithium is not distributed in a peripheral portion of the positive electrode active material of the LFP battery when charging the LFP battery and a second case in which lithium is distributed in a peripheral portion of the positive electrode active material of the LFP battery when charging the LFP battery.

18. The method of clause 17, wherein, in the first case generated in the battery model generating step, the first resistance is a drop resistance considering a voltage difference between a voltage of the LFP battery measured according to at least one of a state of charge (SOC), a charge and discharge rate (c-rate) and a temperature, and an open circuit voltage (OCV) according to at least one of the SOC and the temperature, and the second resistance is 0, and in the second case generated in the battery model generating step, the first resistance is 0, and the second resistance has a value obtained by reflecting a distribution status of lithium in the positive electrode active material of the LFP battery, which changes depending on the SOC, in the drop resistance as a resistance value.

19. The method of any of clauses 16 to 18, wherein the battery model generating step further comprises a step of generating a battery model of the LFP battery by dividing the state of the lithium into a third case in which lithium is not distributed in a peripheral portion of the positive electrode active material of the LFP battery when discharging the LFP battery and a fourth case in which lithium is distributed in a peripheral portion of the positive electrode active material of the LFP battery when discharging the LFP battery.

20. The method of clause 19, wherein, in the fourth case generated in the battery model generating step, the first resistance is 0, and the second resistance is a drop resistance considering a voltage difference between a voltage of the LFP battery measured according to at least one of a state of charge (SOC), a charge and discharge rate (c-rate) and a temperature, and an open circuit voltage (OCV) according to at least one of the SOC and the temperature, and in the third case generated in the battery model generating step, the first resistance has a value obtained by reflecting a distribution status of lithium in the positive electrode active material of the LFP battery, which changes depending on the SOC, in the drop resistance as a resistance value, and the second resistance is 0.

## Claims

**1.** An apparatus for generating a lithium iron phosphate ($LiFePO_4$, LFP) battery model, the apparatus comprising:

a lithium state recording unit configured to record a state of lithium (Li) in positive electrode active material of an LFP battery according to charging or discharging of the LFP battery; and
a battery model generating unit configured to generate a battery model of the LFP battery based on the recorded state of lithium in the positive electrode active material,
wherein the battery model generating unit is configured to generate a battery model by modeling the LFP battery with multiple resistors and capacitors reflecting the state of lithium in the positive electrode active material.

**2.** The apparatus as claimed in claim 1, wherein the lithium state recording unit is configured to record a distribution state of lithium from a peripheral portion to a center in the positive electrode active material of the LFP battery, which changes depending on charging or discharging of the LFP battery.

**3.** The apparatus as claimed in claim 2, wherein the battery model generating unit is configured to generate a battery model of the LFP battery in a form including a first resistance and a second resistance in an equivalent circuit model (ECM).

**4.** The apparatus as claimed in claim 3, wherein the battery model generating unit is configured to generate a battery model of the LFP battery by dividing the state of the lithium into a first case in which lithium is not distributed in a peripheral portion of the positive electrode active material of the LFP battery when charging the LFP battery and a second case in which lithium is distributed in a peripheral portion of the positive electrode active material of the LFP battery when charging the LFP battery.

**5.** The apparatus as claimed in claim 4, wherein, in the first case generated in the battery model generating unit, the first

resistance is a drop resistance considering a voltage difference between a voltage of the LFP battery measured according to at least one of a state of charge (SOC), a charge and discharge rate (c-rate) and a temperature, and an open circuit voltage (OCV) according to at least one of the SOC and the temperature, and the second resistance is 0.

**6.** The apparatus as claimed in claim 5, wherein, when the drop resistance is R_vdrop(soc, c-rate, temp), the voltage of the LFP battery measured according to at least one of an SOC, a charge and discharge rate and a temperature is V_measurement (soc, c-rate, temp), the OCV according to at least one of the SOC and the temperature is V_ocv_ch (soc, temp), and a current flowing through the drop resistance according to the charge and discharge rate is I_c-rate, the first resistance R_a is calculated by the following equation:

[Equation]

$$\begin{aligned} R_a &= R_vdrop(soc,\ c\text{-}rate,\ temp) \\ &= (V_measurement(soc,\ c\text{-}rate,\ temp) - V_ocv_ch(soc,\ temp))/I_c\text{-}rate \end{aligned}$$.

**7.** The apparatus as claimed in claim 6, wherein, in the second case generated in the battery model generating unit, the first resistance is 0, and the second resistance has a value obtained by reflecting a distribution status of lithium in the positive electrode active material of the LFP battery, which changes depending on the SOC, in the drop resistance as a resistance value.

**8.** The apparatus as claimed in claim 7, wherein, when the drop resistance is R_vdrop(soc, c-rate, temp), the closest lithium distribution starting point from the peripheral portion in the positive electrode active material of the LFP battery according to the SOC is K_a(soc), and the closest lithium distribution end point from the peripheral portion in the positive electrode active material of the LFP battery the moment charging starts after a discharge state or a rest state after discharging is K_b_captured, the second resistance R_b is calculated by the following equation:

[Equation]

$$R_b = (K_a(soc)/K_b_captured)) \times R_vdrop(soc,\ c\text{-}rate,\ temp)$$.

**9.** The apparatus as claimed in any of claims 3 to 8, wherein the battery model generating unit is configured to generate a battery model of the LFP battery by dividing the state of the lithium into a third case in which lithium is not distributed in a peripheral portion of the positive electrode active material of the LFP battery when discharging the LFP battery and a fourth case in which lithium is distributed in a peripheral portion of the positive electrode active material of the LFP battery when discharging the LFP battery.

**10.** The apparatus as claimed in claim 9, wherein, in the fourth case generated in the battery model generating unit, the first resistance is 0, and the second resistance is a drop resistance considering a voltage difference between a voltage of the LFP battery measured according to at least one of a state of charge (SOC), a charge and discharge rate (c-rate) and a temperature, and an open circuit voltage (OCV) according to at least one of the SOC and the temperature.

**11.** The apparatus as claimed in claim 10, wherein, when the drop resistance is R_vdrop(soc, c-rate, temp), the voltage of the LFP battery measured according to at least one of an SOC, a charge and discharge rate and a temperature is V_measurement(soc, c-rate, temp), the OCV according to at least one of the SOC and the temperature is V_ocv_ch(soc, temp), and a current flowing through the drop resistance according to the charge and discharge rate is I_c-rate, the second resistance R_b is calculated by the following equation:

[Equation]

$$\begin{aligned} R_b &= R_vdrop(soc,\ c\text{-}rate,\ temp) \\ &= (V_measurement(soc,\ c\text{-}rate,\ temp) - V_ocv_ch(soc,\ temp))/I_c\text{-}rate \end{aligned}$$.

**12.** The apparatus as claimed in claim 11, wherein, in the third case generated in the battery model generating unit, the first resistance has a value obtained by reflecting a distribution status of lithium in the positive electrode active material of

the LFP battery, which changes depending on the SOC, in the drop resistance as a resistance value, and the second resistance is 0.

**13.** The apparatus as claimed in claim 12, wherein, when the drop resistance is R_vdrop(soc, c-rate, temp), the closest lithium distribution end point from the peripheral portion in the positive electrode active material of the LFP battery according to the SOC is K_b(soc), the closest lithium distribution starting point from the peripheral portion in the positive electrode active material of the LFP battery the moment discharging starts after a charge state or a rest state after charging is K_a_captured, the first resistance R_a is calculated by the following equation:

[Equation]

$$R_a = (K_b(soc)/K_a_captured)) \times R_vdrop(soc, c\text{-}rate, temp).$$

**14.** A method for generating a lithium iron phosphate ($LiFePO_4$, LFP) battery model, the method comprising:

a lithium state recording step of recording a state of lithium (Li) in positive electrode active material of an LFP battery according to charging or discharging of the LFP battery in a lithium state recording unit; and
a battery model generating step of generating a battery model of the LFP battery based on the recorded state of lithium in the positive electrode active material in a battery model generating unit,
wherein the battery model generating step includes a step of generating a battery model by modeling the LFP battery with multiple resistors and capacitors reflecting the state of lithium in the positive electrode active material.

**15.** The method as claimed in claim 14, wherein the lithium state recording step comprises a step of recording a distribution state of lithium from a peripheral portion to a center in the positive electrode active material of the LFP battery, which changes depending on charging or discharging of the LFP battery.

FIG. 1

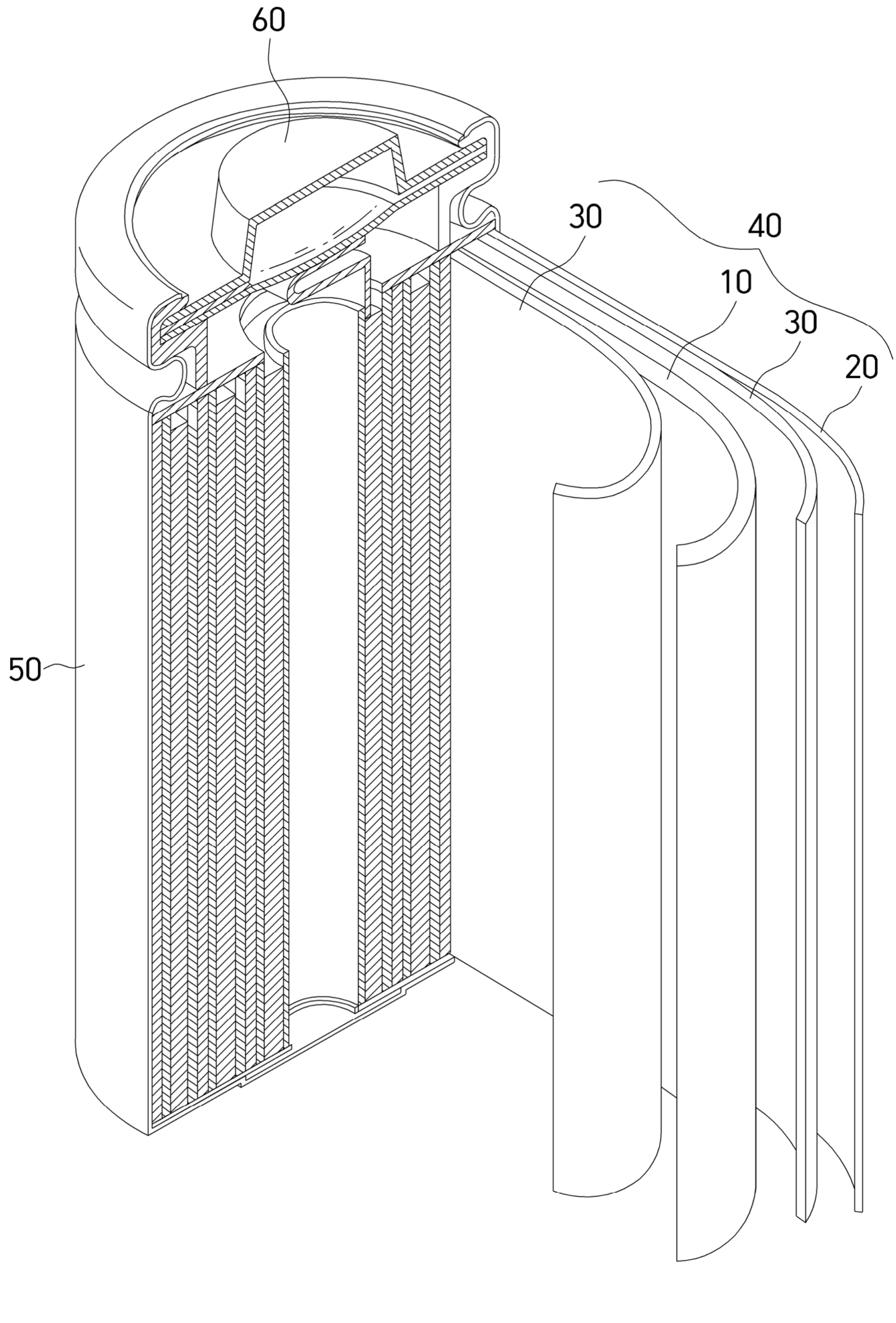

FIG. 2

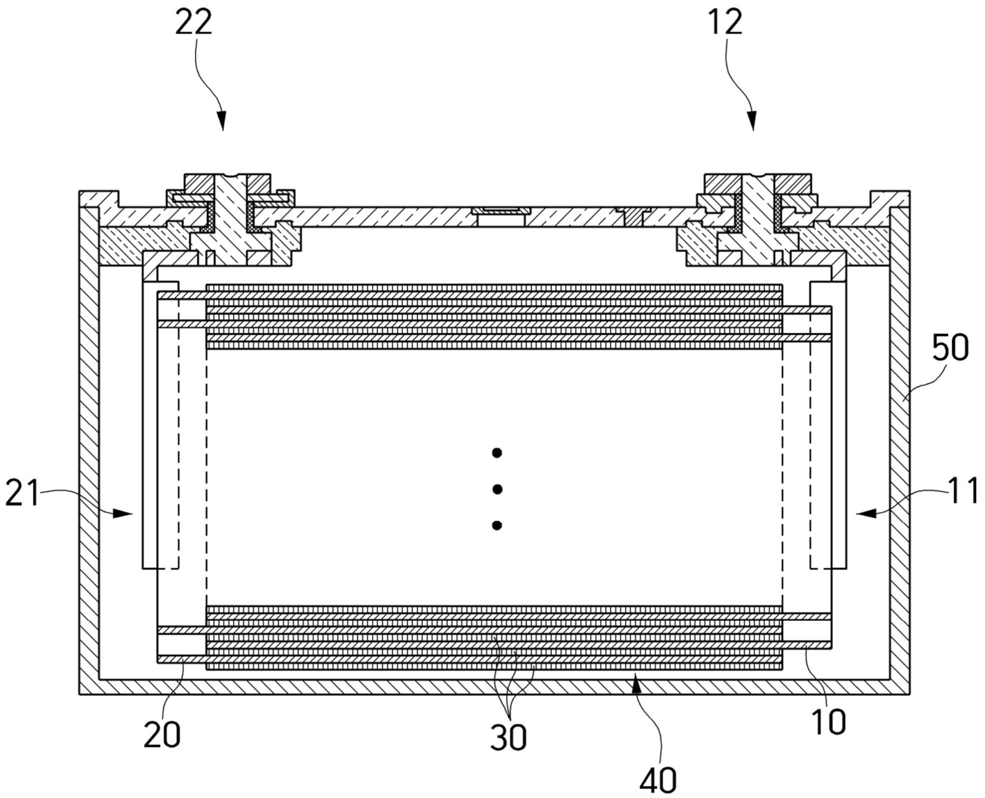

FIG. 3

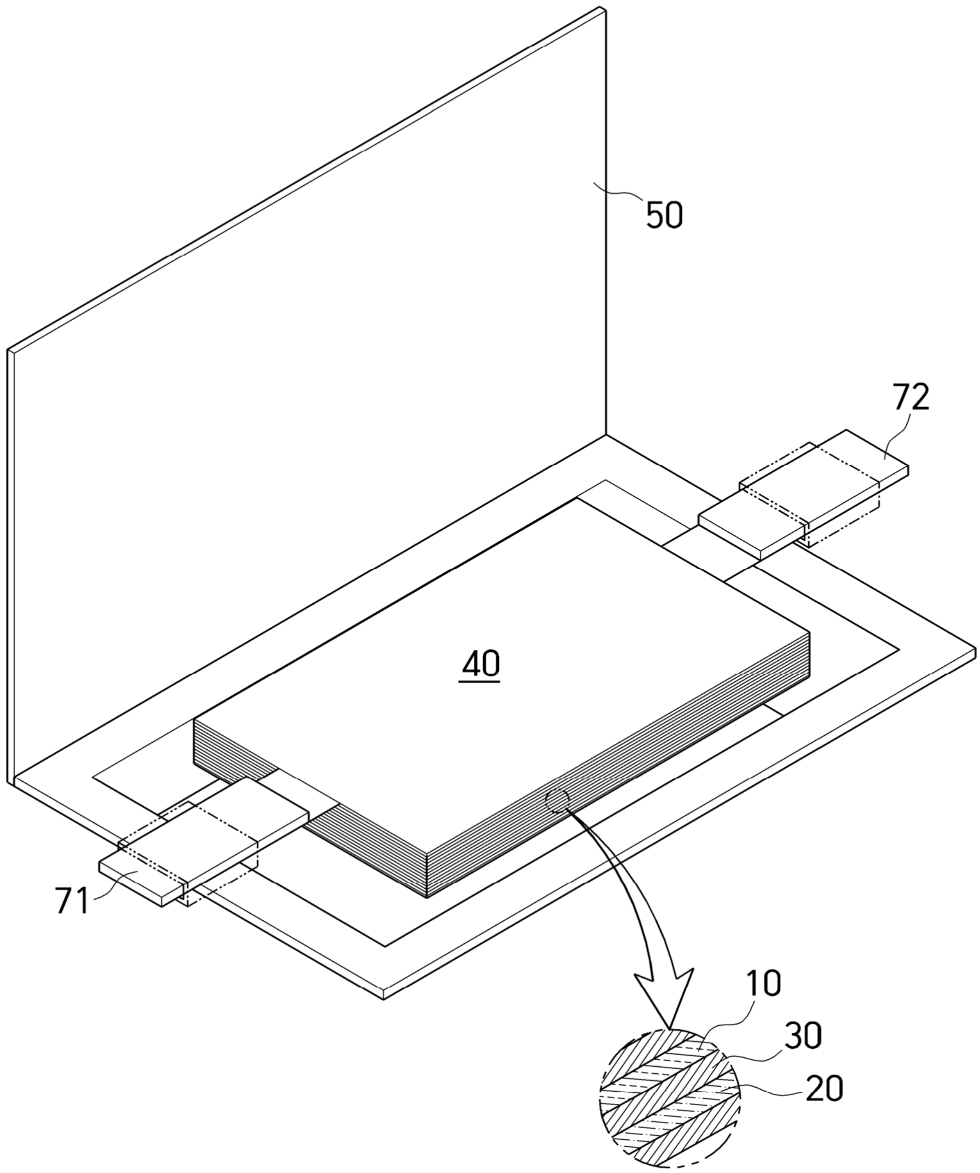

FIG. 4

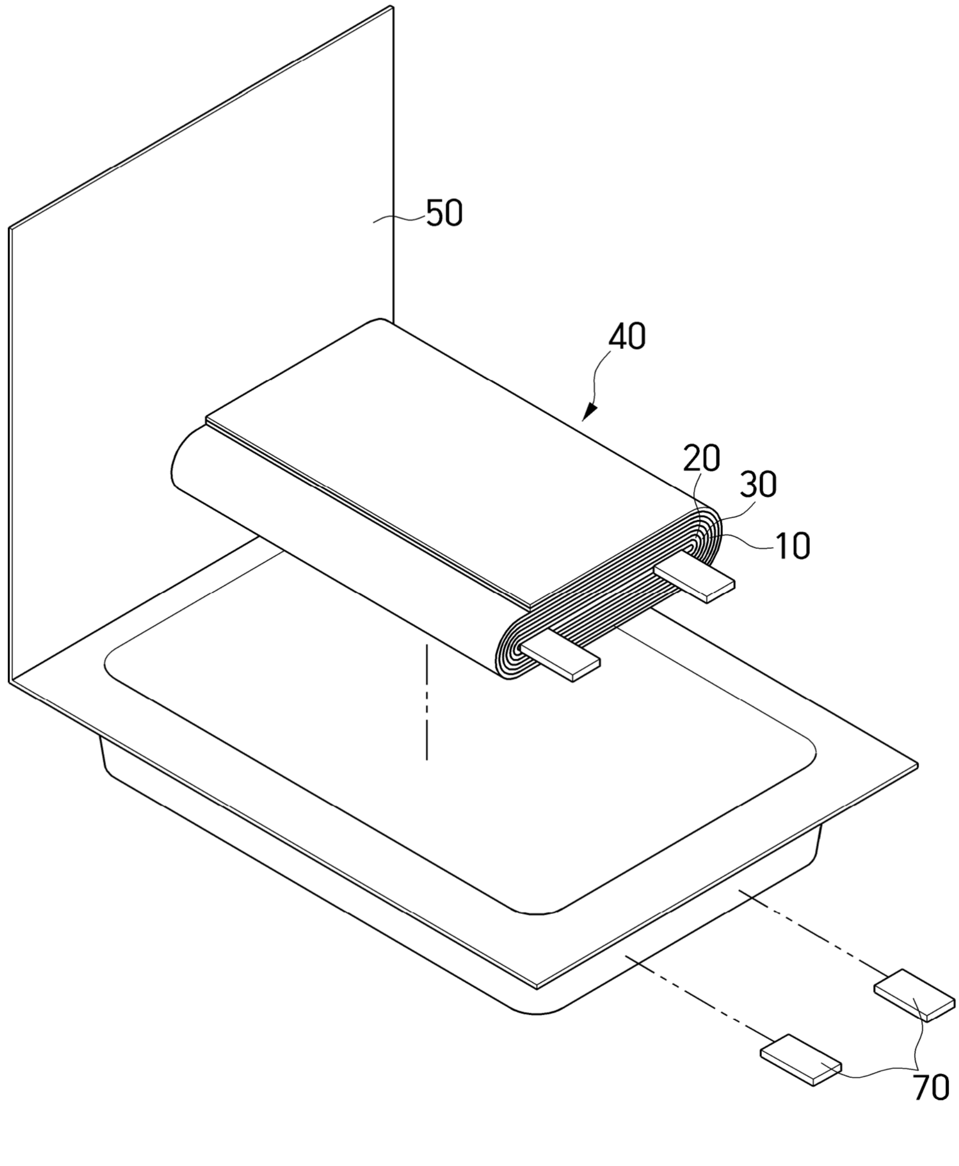

FIG. 5

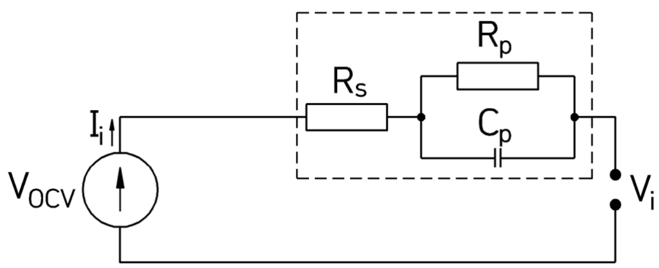

FIG. 6

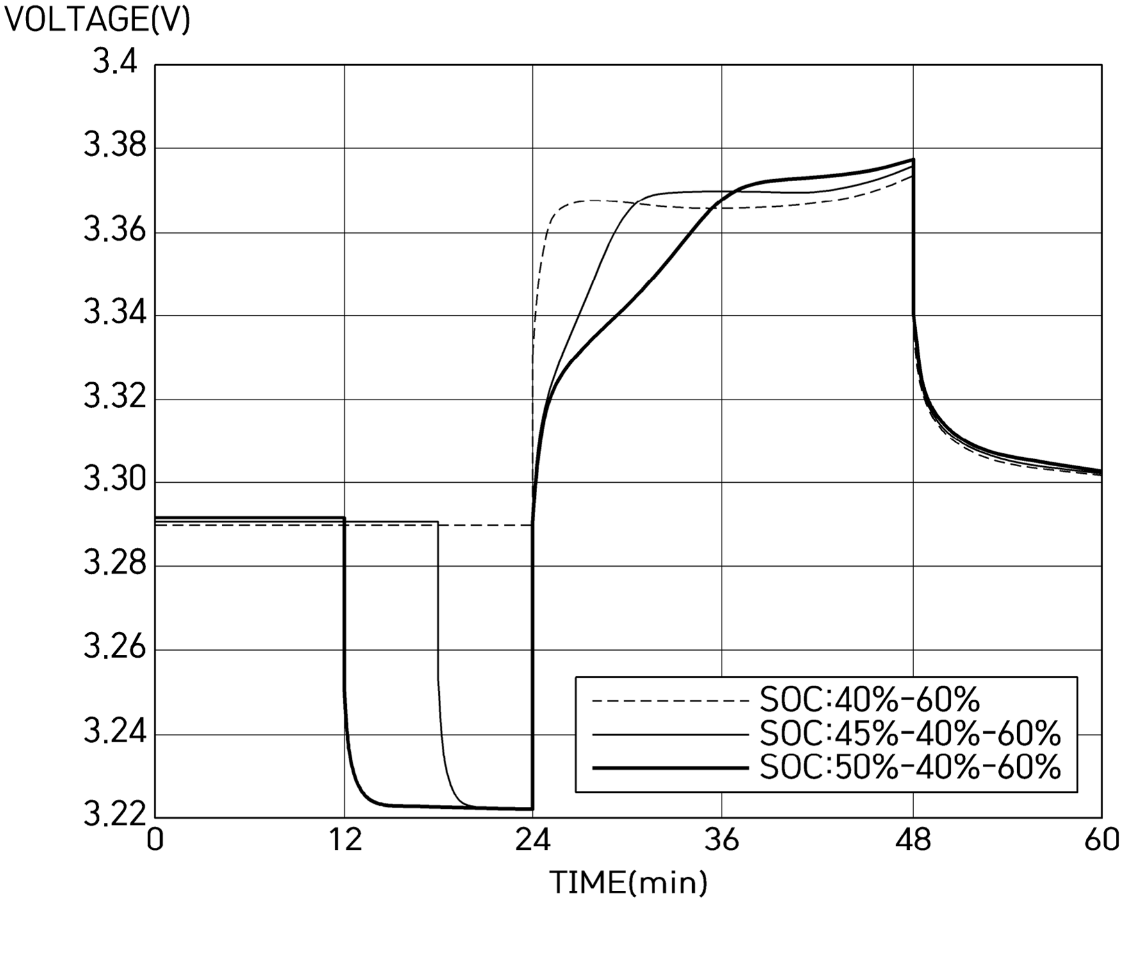
VOLTAGE(V)
3.4
3.38
3.36
3.34
3.32
3.30
3.28
3.26
3.24
3.22
0
12
24
36
48
60
TIME(min)
SOC:40%-60%
SOC:45%-40%-60%
SOC:50%-40%-60%

FIG. 7

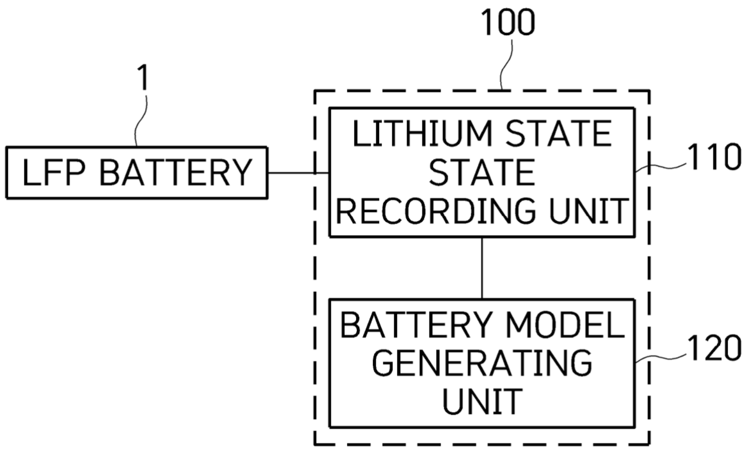
100
1
LFP BATTERY
LITHIUM STATE
STATE
RECORDING UNIT
110
BATTERY MODEL
GENERATING
UNIT
120

FIG. 8

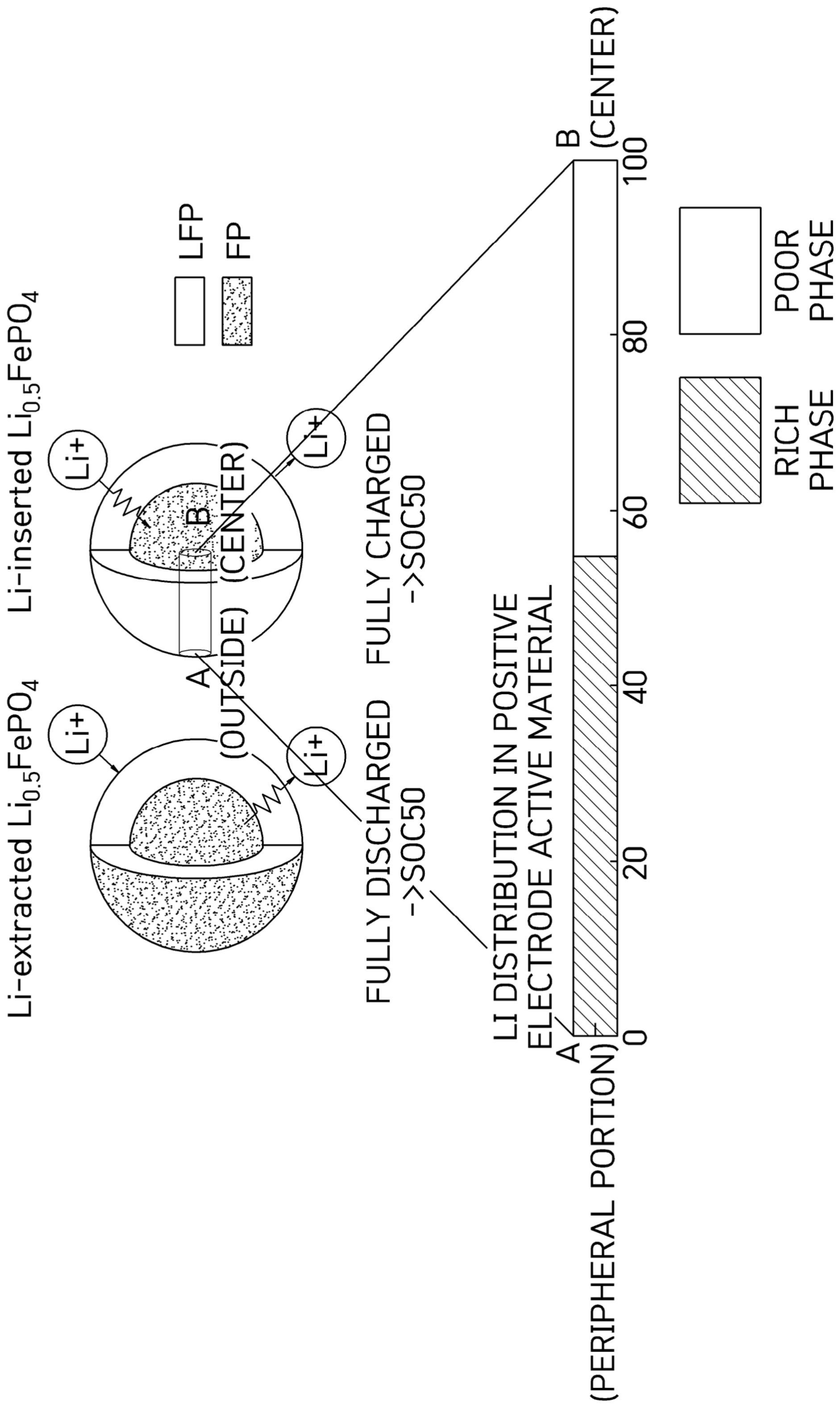
Li-extracted $Li_{0.5}FePO_4$
Li-inserted $Li_{0.5}FePO_4$
Li+
Li+
Li+
Li+
LFP
FP
A
(OUTSIDE)
B
(CENTER)
FULLY DISCHARGED
->SOC50
FULLY CHARGED
->SOC50
LI DISTRIBUTION IN POSITIVE
ELECTRODE ACTIVE MATERIAL
A
(PERIPHERAL PORTION)
B
(CENTER)
0
20
40
60
80
100
RICH
PHASE
POOR
PHASE

FIG. 9

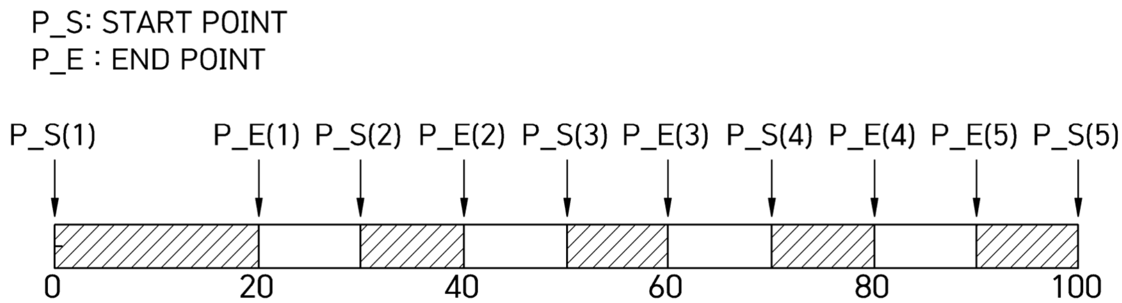
P_S: START POINT
P_E : END POINT
P_S(1)
P_E(1)
P_S(2)
P_E(2)
P_S(3)
P_E(3)
P_S(4)
P_E(4)
P_E(5)
P_S(5)
0
20
40
60
80
100

FIG. 10

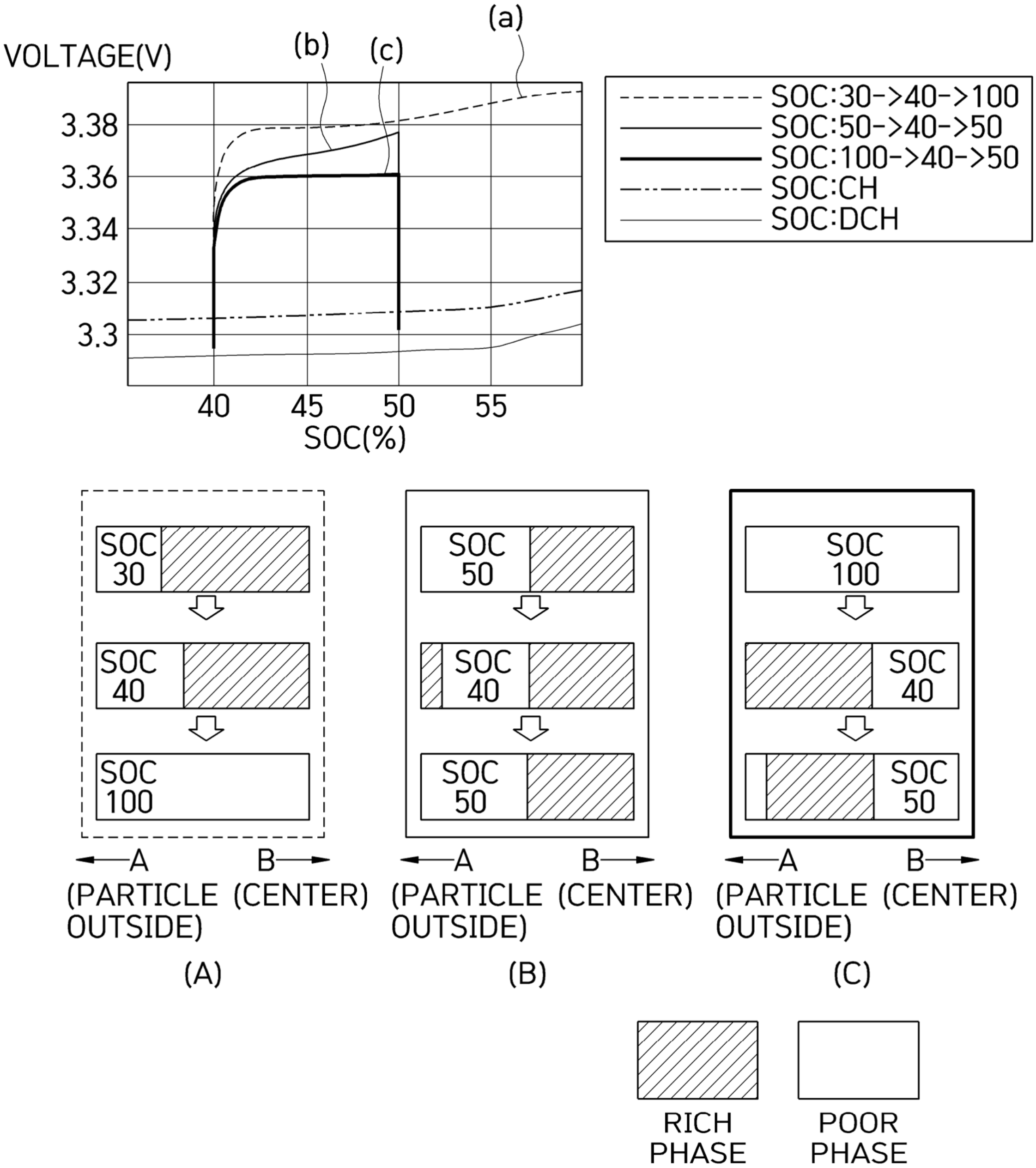
VOLTAGE(V)
(a)
(b)
(c)
3.38
3.36
3.34
3.32
3.3
40
45
50
55
SOC(%)
SOC:30->40->100
SOC:50->40->50
SOC:100->40->50
SOC:CH
SOC:DCH
SOC 30
SOC 40
SOC 100
SOC 50
SOC 40
SOC 50
SOC 100
SOC 40
SOC 50
A
B
(PARTICLE OUTSIDE)
(CENTER)
(A)
(B)
(C)
RICH PHASE
POOR PHASE

FIG. 11

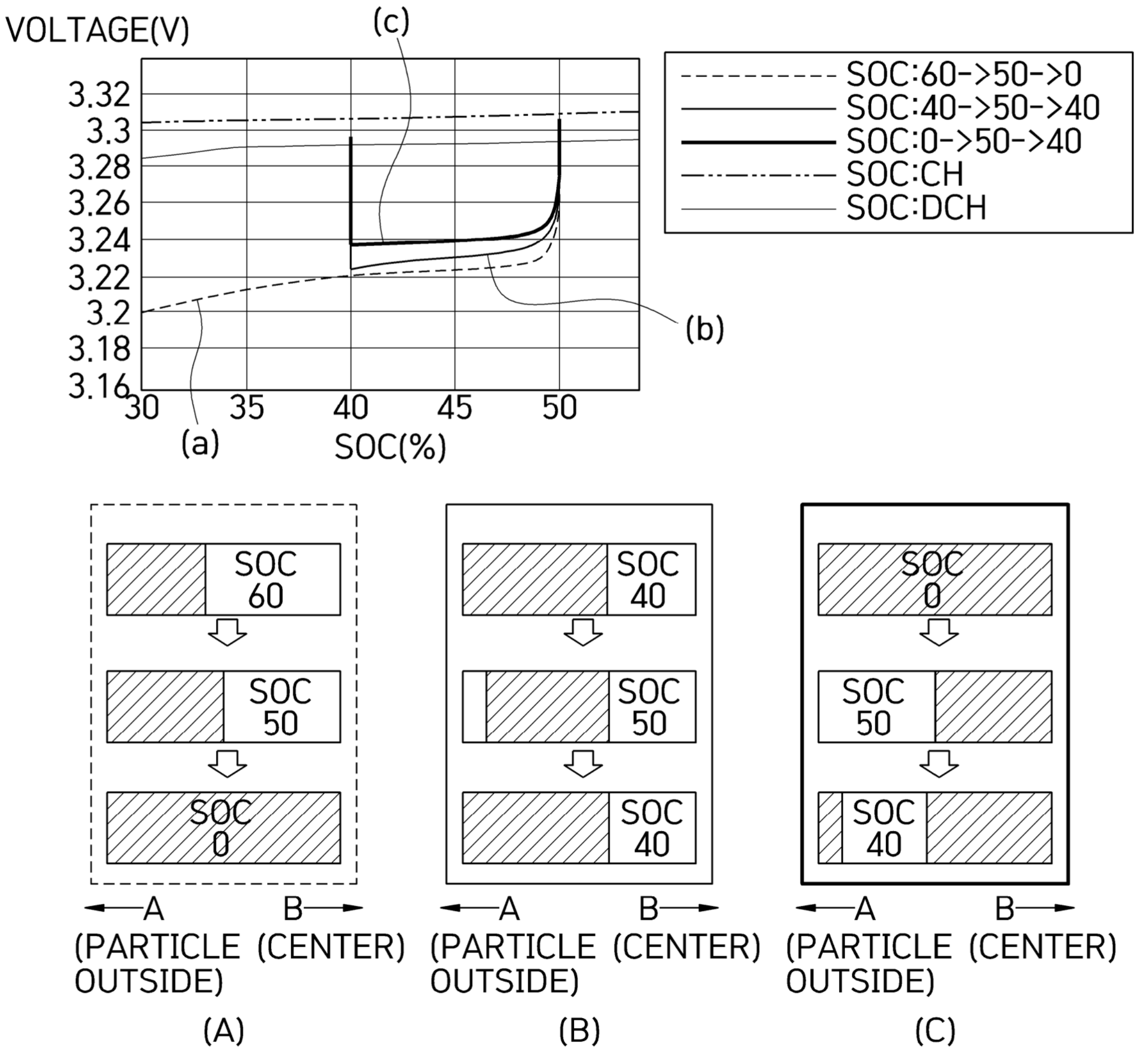
VOLTAGE(V)
3.32
3.3
3.28
3.26
3.24
3.22
3.2
3.18
3.16
30
35
40
45
50
SOC(%)
(a)
(b)
(c)
SOC:60->50->0
SOC:40->50->40
SOC:0->50->40
SOC:CH
SOC:DCH
SOC 60
SOC 50
SOC 0
SOC 40
SOC 50
SOC 40
SOC 0
SOC 50
SOC 40
A (PARTICLE OUTSIDE)
B (CENTER)
(A)
(B)
(C)

FIG. 12

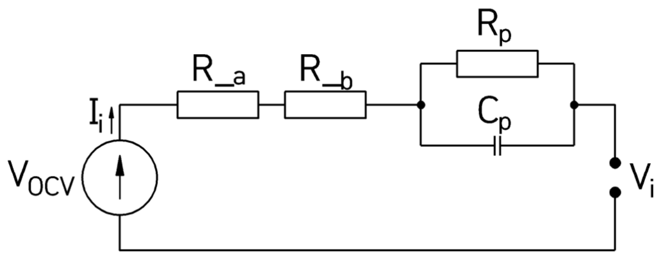

FIG. 13

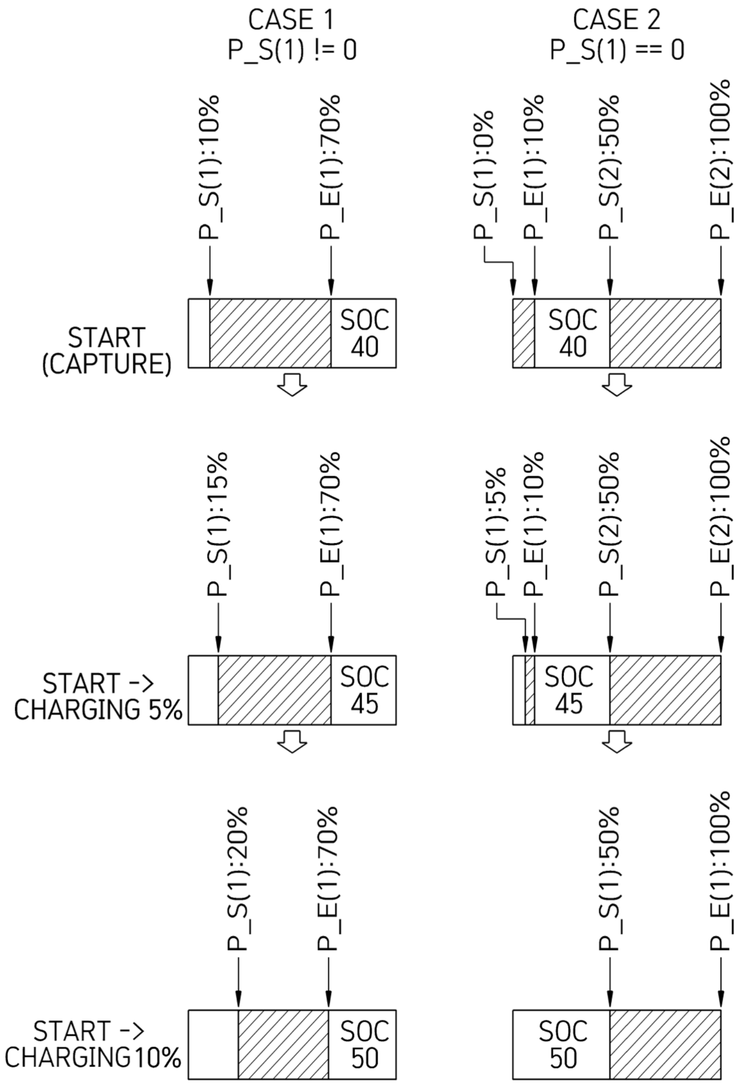
CASE 1
P_S(1) != 0
CASE 2
P_S(1) == 0
P_S(1):10%
P_E(1):70%
START
(CAPTURE)
SOC
40
P_S(1):0%
P_E(1):10%
P_S(2):50%
P_E(2):100%
SOC
40
P_S(1):15%
P_E(1):70%
START ->
CHARGING 5%
SOC
45
P_S(1):5%
P_E(1):10%
P_S(2):50%
P_E(2):100%
SOC
45
P_S(1):20%
P_E(1):70%
START ->
CHARGING 10%
SOC
50
P_S(1):50%
P_E(1):100%
SOC
50

FIG. 14

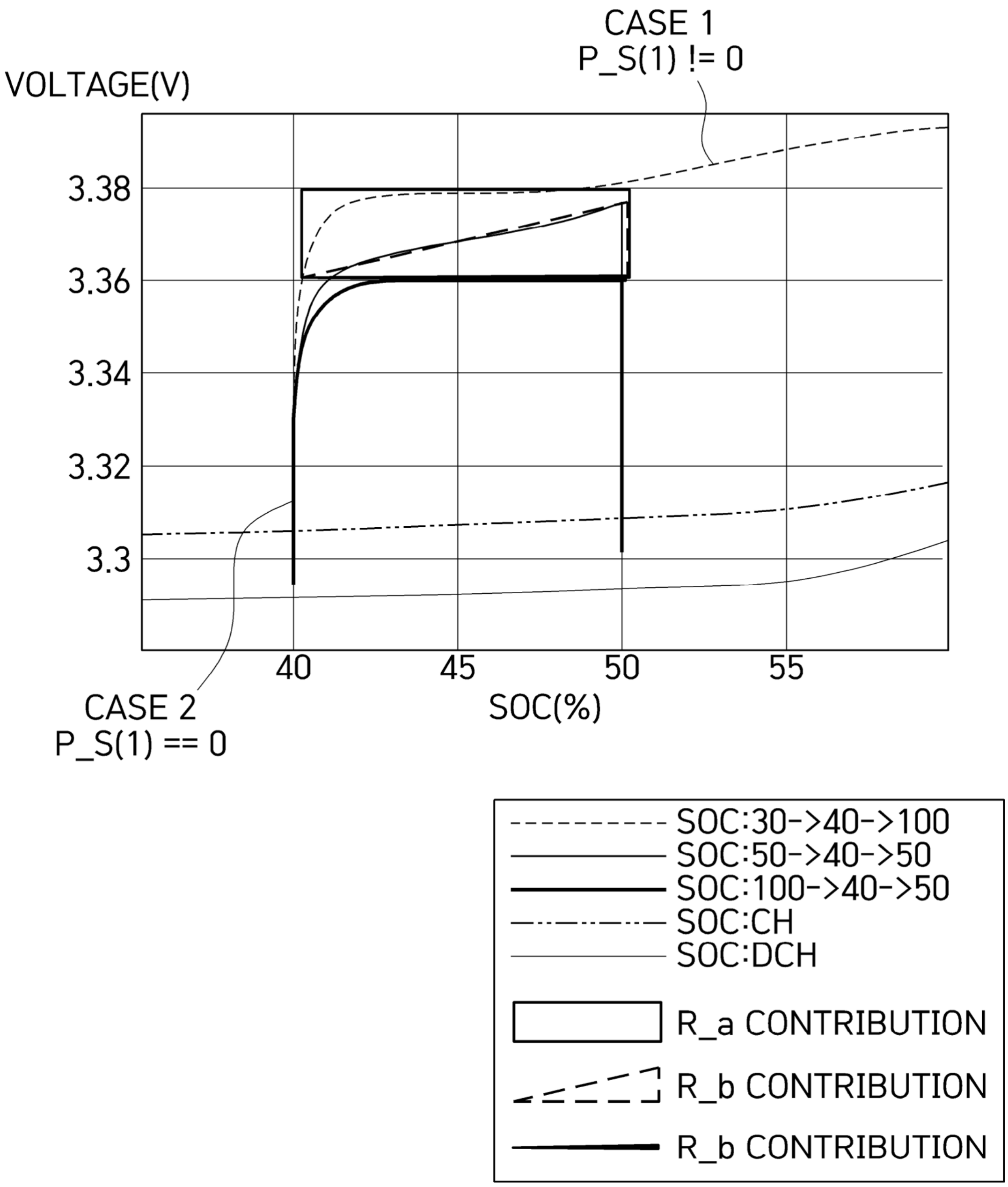
CASE 1
P_S(1) != 0
VOLTAGE(V)
3.38
3.36
3.34
3.32
3.3
40
45
50
55
SOC(%)
CASE 2
P_S(1) == 0
SOC:30->40->100
SOC:50->40->50
SOC:100->40->50
SOC:CH
SOC:DCH
R_a CONTRIBUTION
R_b CONTRIBUTION
R_b CONTRIBUTION

FIG. 15

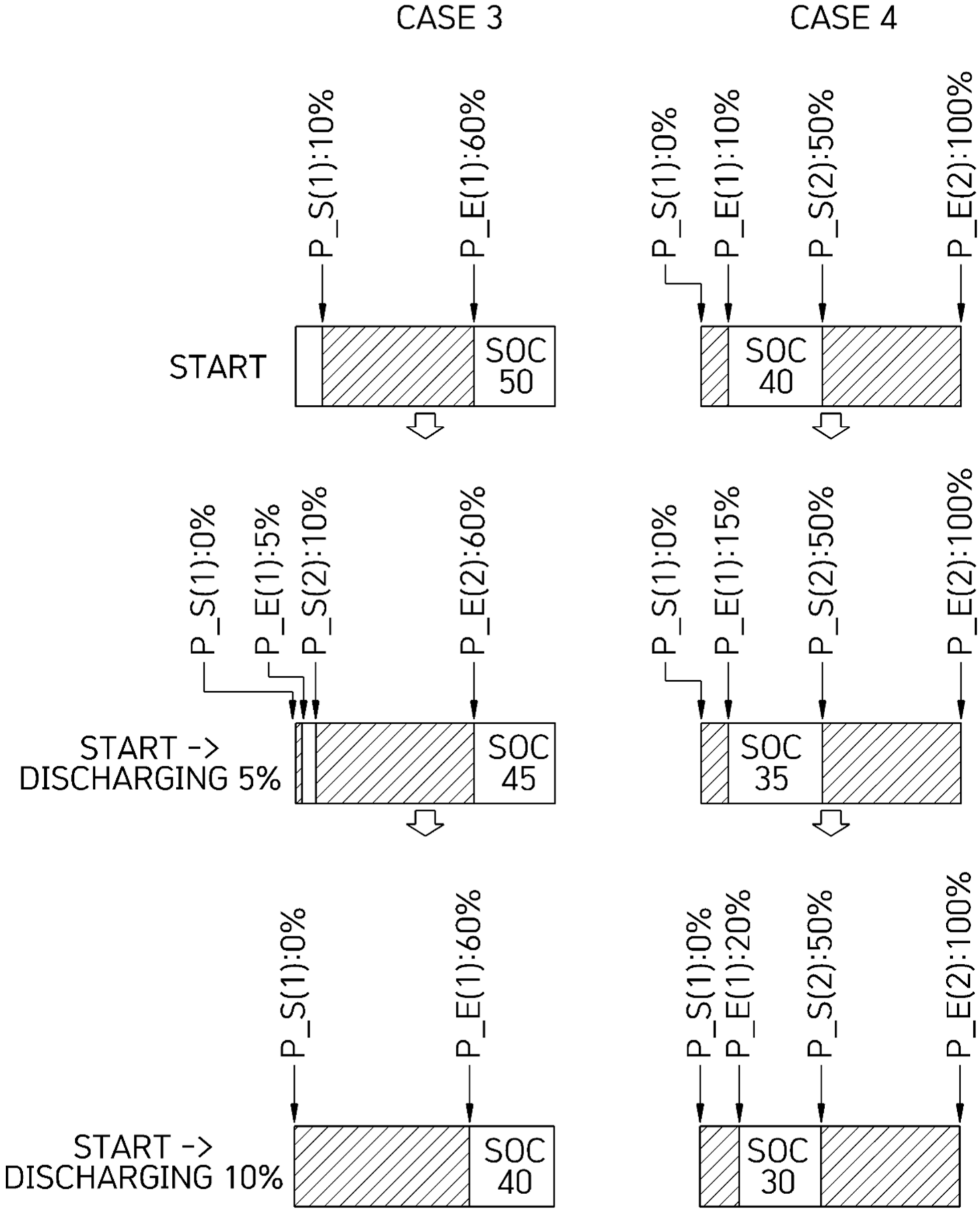
CASE 3
CASE 4
P_S(1):10%
P_E(1):60%
START
SOC 50
P_S(1):0%
P_E(1):10%
P_S(2):50%
P_E(2):100%
SOC 40
P_S(1):0%
P_E(1):5%
P_S(2):10%
P_E(2):60%
START -> DISCHARGING 5%
SOC 45
P_S(1):0%
P_E(1):15%
P_S(2):50%
P_E(2):100%
SOC 35
P_S(1):0%
P_E(1):60%
START -> DISCHARGING 10%
SOC 40
P_S(1):0%
P_E(1):20%
P_S(2):50%
P_E(2):100%
SOC 30

FIG. 16

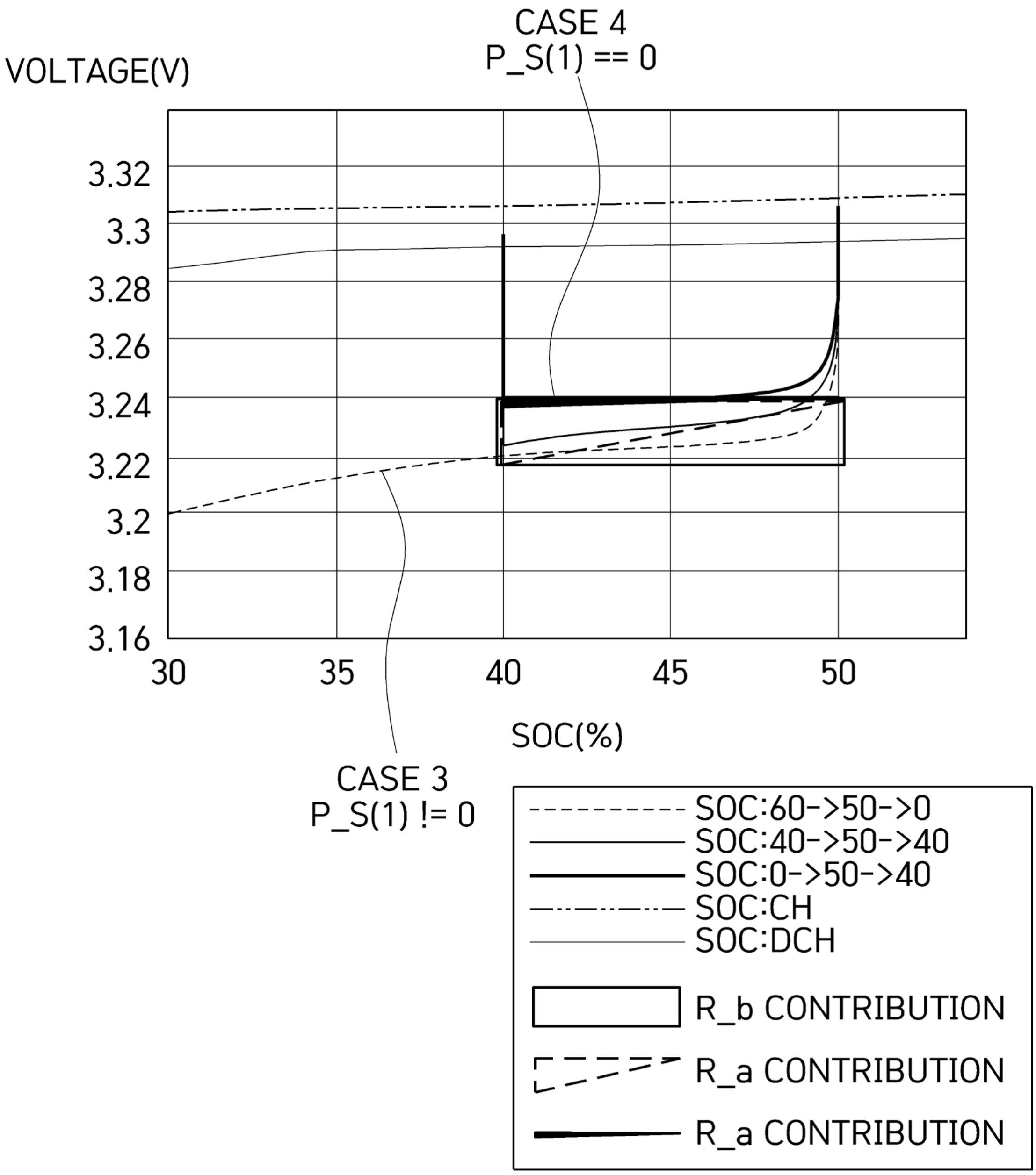
CASE 4
P_S(1) == 0
VOLTAGE(V)
3.32
3.3
3.28
3.26
3.24
3.22
3.2
3.18
3.16
30
35
40
45
50
SOC(%)
CASE 3
P_S(1) != 0
SOC:60->50->0
SOC:40->50->40
SOC:0->50->40
SOC:CH
SOC:DCH
R_b CONTRIBUTION
R_a CONTRIBUTION
R_a CONTRIBUTION

FIG. 17

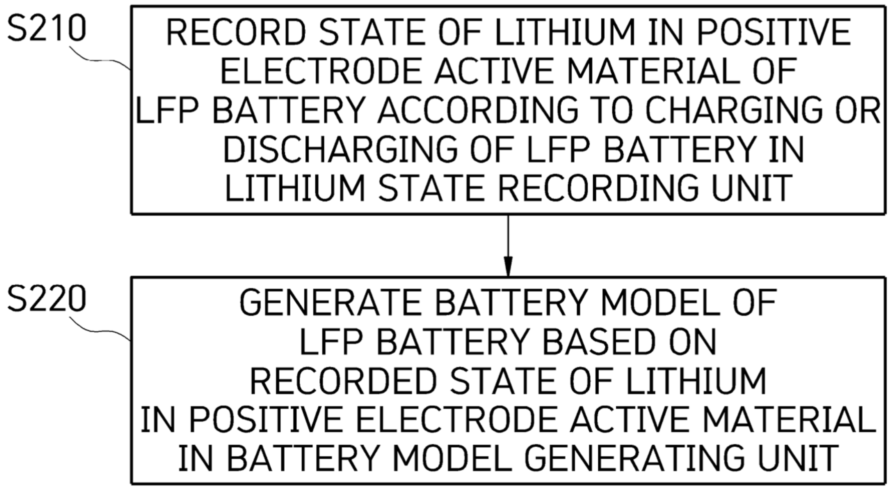
S210
RECORD STATE OF LITHIUM IN POSITIVE ELECTRODE ACTIVE MATERIAL OF LFP BATTERY ACCORDING TO CHARGING OR DISCHARGING OF LFP BATTERY IN LITHIUM STATE RECORDING UNIT
S220
GENERATE BATTERY MODEL OF LFP BATTERY BASED ON RECORDED STATE OF LITHIUM IN POSITIVE ELECTRODE ACTIVE MATERIAL IN BATTERY MODEL GENERATING UNIT

Europäisches Patentamt
European Patent Office
Office européen des brevets

# EUROPEAN SEARCH REPORT

Application Number
EP 25 21 8469

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 110 780 205 A (IT ELECT 11TH DESIGN & RES INST SCI & TECH ENG CORP) 11 February 2020 (2020-02-11) | 1,14 | INV. H01M10/42 G01R31/367 G01R31/378 G01R31/382 G01R31/387 H01M10/48 H01M4/58 |
| A | * claims 1,2 * | 2-13,15 | |
| | ----- | | |
| X | US 9 393 921 B1 (WEICKER PHILLIP JOHN [US] ET AL) 19 July 2016 (2016-07-19) | 1,14 | |
| A | * claims 1-25 * | 2-13,15 | |
| | ----- | | |
| X | EP 2 952 919 A1 (LG CHEMICAL LTD [KR]) 9 December 2015 (2015-12-09) | 1,14 | |
| A | * claims 1-25 * * paragraphs [0092] - [0094], [0105] - [0108], [0123] - [0129], [0140] * * figure 2 * | 2-13,15 | |
| | ----- | | |
| X | CN 105 203 969 A (UNIV NANCHANG HANGKONG) 30 December 2015 (2015-12-30) | 1,14 | |
| A | * claims 1-2 * | 2-13,15 | |
| | ----- | | |
| X | CN 103 793 605 A (ZHEJIANG MEASUREMENT SCIENCE RES INST) 14 May 2014 (2014-05-14) | 1,14 | TECHNICAL FIELDS SEARCHED (IPC) |
| A | * claim 1 * | 2-13,15 | H01M G01R |
| | ----- | | |
| X | CN 106 909 716 A (UNIV NORTHEAST DIANLI) 30 June 2017 (2017-06-30) | 1,14 | |
| A | * claims 1-5 * | 2-13,15 | |
| | ----- | | |
| X | KR 2024 0023762 A (LG ENERGY SOLUTION LTD [KR]) 23 February 2024 (2024-02-23) | 1,14 | |
| A | * claims 1-7 * * paragraph [0090] * | 2-13,15 | |
| | ----- | | |
| X | CN 107 255 786 A (ZHONGSHAN POLYTECHNIC) 17 October 2017 (2017-10-17) | 1,14 | |
| A | * claims 1-6 * | 2-13,15 | |
| | ----- | | |

The present search report has been drawn up for all claims

1

| Place of search | Date of completion of the search | Examiner |
|---|---|---|
| Munich | 24 March 2026 | Haering, Christian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
..................................................
& : member of the same patent family, corresponding document

EPO FORM 1503 03.82 (P04C01)

## ANNEX TO THE EUROPEAN SEARCH REPORT ON EUROPEAN PATENT APPLICATION NO. EP 25 21 8469

This annex lists the patent family members relating to the patent documents cited in the above-mentioned European search report. The members are as contained in the European Patent Office EDP file on
The European Patent Office is in no way liable for these particulars which are merely given for the purpose of information.

24-03-2026

| Patent document cited in search report | Publication date | Patent family member(s) | Publication date |
|---|---|---|---|
| CN 110780205 A | 11-02-2020 | NONE | |
| US 9393921 B1 | 19-07-2016 | NONE | |
| EP 2952919 A1 | 09-12-2015 | CN 104541175 A | 22-04-2015 |
| | | EP 2952919 A1 | 09-12-2015 |
| | | JP 6524182 B2 | 05-06-2019 |
| | | JP 2016508214 A | 17-03-2016 |
| | | JP 2018031795 A | 01-03-2018 |
| | | KR 20140071929 A | 12-06-2014 |
| | | US 2015084639 A1 | 26-03-2015 |
| | | WO 2014088324 A1 | 12-06-2014 |
| CN 105203969 A | 30-12-2015 | NONE | |
| CN 103793605 A | 14-05-2014 | NONE | |
| CN 106909716 A | 30-06-2017 | NONE | |
| KR 20240023762 A | 23-02-2024 | CN 119731545 A | 28-03-2025 |
| | | EP 4564025 A1 | 04-06-2025 |
| | | JP 2025523167 A | 17-07-2025 |
| | | KR 20240023762 A | 23-02-2024 |
| | | US 20260037686 A1 | 05-02-2026 |
| | | WO 2024039169 A1 | 22-02-2024 |
| CN 107255786 A | 17-10-2017 | NONE | |

EPO FORM P0459

For more details about this annex : see Official Journal of the European Patent Office, No. 12/82